# EUROPEAN PATENT APPLICATION

(11) **EP 4 322 722 A1**
(43) Date of publication of application: **14.02.2024**
(21) Application number: 23173481.5
(22) Date of filing: 15.05.2023
(51) Int. Cl.: H10B 43/27, H10B 43/40, H10B 43/10

(54) **SEMICONDUCTOR MEMORY DEVICE AND ELECTRONIC SYSTEM INCLUDING THE SAME**

(30) Priority: 11.08.2022 KR 20220100494
(71) Applicant: Samsung Electronics Co., Ltd., Suwon-si, Gyeonggi-do 16677 (KR)
(72) Inventor: CHOI, Moorym, 16677 Suwon-si (KR); SUNG, Jungtae, 16677 Suwon-si (KR); SHIM, Sunil, 16677 Suwon-si (KR); JANG, Yunsun, 16677 Suwon-si (KR)
(74) Representative: Marks & Clerk LLP

(57) **Abstract**

A semiconductor memory device includes: a stack including interlayer insulating layers and conductive patterns, which are alternately stacked; a source conductive pattern on the stack; and vertical structures provided to penetrate the stack and connected to the source conductive pattern. Each of the vertical structures includes: a vertical channel pattern; a data storage pattern enclosing an outer side surface of the vertical channel pattern; a vertical insulating pillar in the vertical channel pattern; and a vertical conductive pillar disposed between the vertical insulating pillar and the source conductive pattern to connect the vertical channel pattern to the source conductive pattern.

## Description

### 1. Field

The present invention relates to a semiconductor memory device. The disclosure further describes an electronic system including the device.

### 2. Background

A semiconductor device capable of storing a large capacity of data is desired as a part of an electronic system. Accordingly, many studies are being conducted to increase the data storage capacity of the semiconductor device. For example, semiconductor devices, in which memory cells are three-dimensionally arranged, are being suggested.

### SUMMARY

According to the present invention, there is provided a semiconductor memory device according to claim 1. Preferred embodiments are defined by the dependent claims.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 illustrates an electronic system including a semiconductor memory device according to an embodiment of the present disclosure;
FIG. 2 illustrates an electronic system including a semiconductor memory device according to an embodiment of the present disclosure;
FIGS. 3 and 4 illustrate semiconductor packages according to an embodiment of the present disclosure;
FIG. 5 illustrates a semiconductor memory device according to an embodiment of the present disclosure;
FIG. 6A illustrates a sectional view of a semiconductor memory device, which is taken along a line A-A' of FIG. 5, according to an embodiment of the present disclosure;
FIG. 6B illustrates a sectional view of a semiconductor memory device, which is taken along a line B-B' of FIG. 5, according to an embodiment of the present disclosure;
FIGS. 7A to 7F illustrate a portion ('P1' of FIG. 6B) of a semiconductor memory device according to an embodiment of the present disclosure;
FIGS. 8A to 8D illustrate a portion 'A1' of FIG. 7A;
FIGS. 9A to 9B illustrate a portion 'A2' of FIG. 7B;
FIGS. 10 to 15 illustrate sectional views of a semiconductor memory device, which are taken along the line A-A' of FIG. 5, according to an embodiment of the present disclosure; and
FIGS. 16 to 22 illustrate sectional views of a portion `P2' of FIG. 15, according to an embodiment of the present disclosure.

### DETAILED DESCRIPTION

An embodiment of the present disclosure provides a semiconductor memory device with improved reliability and an increased integration density. An embodiment of the present disclosure provides an electronic system including the semiconductor memory device.

According to an example of the present disclosure, a semiconductor memory device includes: a stack including interlayer insulating layers and conductive patterns, which are alternately stacked; a source conductive pattern on the stack; and vertical structures provided to penetrate the stack and connected to the source conductive pattern. Each of the vertical structures includes: a vertical channel pattern; a data storage pattern enclosing an outer side surface of the vertical channel pattern; a vertical insulating pillar in the vertical channel pattern; and a vertical conductive pillar disposed between the vertical insulating pillar and the source conductive pattern to connect the vertical channel pattern to the source conductive pattern. (The structures, channel pattern, insulating pillar and conductive pillar are preferably (i.e., optionally) vertical. Preferably, they extend in a direction substantially perpendicular to the interlayer insulating layers and conductive patterns of the stack).

In an embodiment, a conductive pattern of the conductive patterns is provided to enclose the conductive pillar and the conductive pattern is adjacent to the source conductive pattern. The conductive pattern is preferably an uppermost conductive pattern of the conductive patterns. In an embodiment, the source conductive pattern may comprise (i) a horizontal portion that is parallel to the stack and (ii) protruding portions that protrude from the horizontal portion. An embodiment may further comprise an insulating reflection layer between the source conductive pattern and an interlayer insulating layer that is the closest of the interlayer insulating layers to the source conductive pattern, preferably wherein the interlayer insulating layer is uppermost of the interlayer insulating layers. In an embodiment, the source conductive pattern is in contact with a surface of an interlayer insulating layer of the interlayer insulating layers of the stack and a surface of the data storage pattern, preferably wherein the interlayer insulting layer is the closest of the interlayer insulating layers to the source conductive pattern, further preferably wherein: the interlayer insulating layer is uppermost of the interlayer insulating layers, the surface of the interlayer insulating layer is a top surface and/or the surface of the data storage pattern is a top surface.

According to another example of the present disclosure, a semiconductor memory device includes: a substrate; a peripheral circuit structure including (i) peripheral circuits that are integrated on the substrate and (ii) first bonding pads that are connected to the peripheral circuits; and a cell array structure including second bonding pads that are bonded to the first bonding pads. The cell array structure includes: a stack including interlayer insulating layers and conductive patterns, which are alternately stacked; a source conductive pattern on the stack; and vertical structures provided to penetrate the stack and connected to the source conductive pattern. Each of the vertical structures includes: a vertical channel pattern, a data storage pattern enclosing an outer side surface of the vertical channel pattern, a vertical insulating pillar in the vertical channel pattern, and a vertical conductive pillar disposed between the vertical insulating pillar and the source conductive pattern to connect the vertical channel pattern to the source conductive pattern. A uppermost conductive pattern of the conductive patterns may enclose the vertical conductive pillar, and the uppermost conductive pattern is adjacent to the source conductive pattern.

According to another example of the present disclosure, an electronic system includes: a semiconductor memory device including a substrate, a peripheral circuit structure on the substrate, and a cell array structure on the peripheral circuit structure; and a controller that is electrically connected to the semiconductor memory device through an input/output pad. The controller is used to control the semiconductor memory device. The cell array structure includes: a stack including interlayer insulating layers and conductive patterns that are alternately stacked; a source conductive pattern on the stack; and vertical structures provided to penetrate the stack and connected to the source conductive pattern. Each of the vertical structures includes: a vertical channel pattern; a data storage pattern enclosing an outer side surface of the vertical channel pattern; a vertical insulating pillar in the vertical channel pattern; and a vertical conductive pillar disposed between the vertical insulating pillar and the source conductive pattern to connect the vertical channel pattern to the source conductive pattern.

Generally speaking:
- references herein to 'input/output' relate to input and/or output, e.g., either or both of input and output.
- references herein to 'vertical' generally mean a direction substantially (e.g., exactly) perpendicular to the stack, e.g., to planes of the interlayer insulating layers and conductive patterns of the stack. Such a direction may penetrate through the interlayer insulating layers and conductive patterns of the stack; and
- references herein to 'horizontal' or 'lateral' generally mean a direction substantially (e.g., exactly) parallel to the stack, e.g., to preferably all planes of the interlayer insulating layers and conductive patterns of the stack;
- references herein to 'uppermost' generally mean closest to the source conductive pattern.

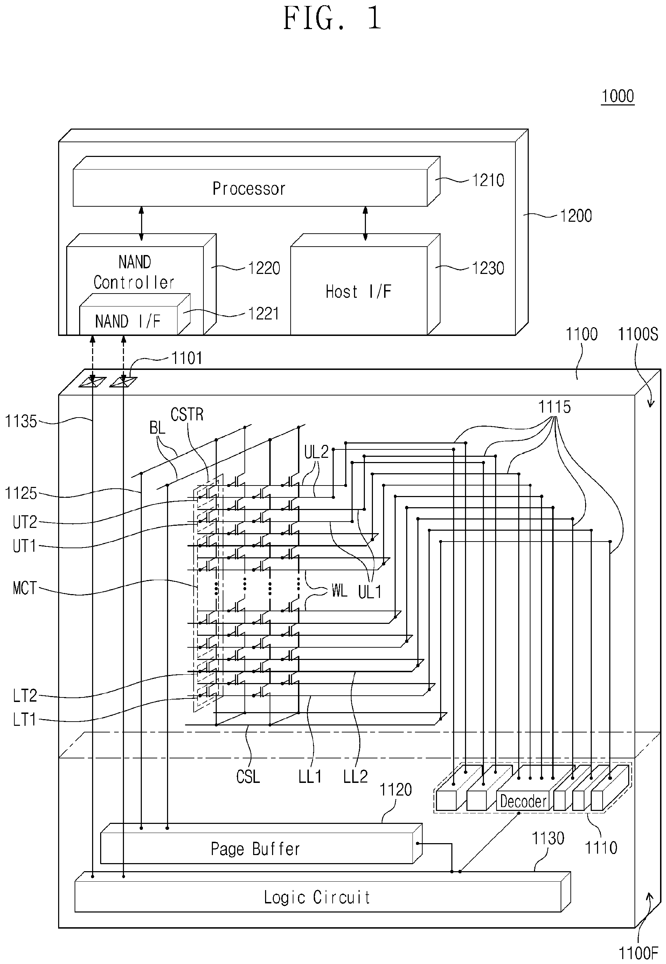

Example embodiments of the present disclosure will now be described more fully with reference to the accompanying drawings, in which example embodiments are shown. FIG. 1 is a diagram schematically illustrating an electronic system including a semiconductor memory device according to an embodiment of the present disclosure. In FIG. 1, an electronic system 1000 according to an embodiment of the present disclosure may include a semiconductor memory device 1100 and a controller 1200, which is electrically connected to the semiconductor memory device 1100.

The electronic system 1000 may be a storage device, which includes one or more semiconductor memory devices 1100, or an electronic device including the storage device. For example, the electronic system 1000 may be a Solid State Drive (SSD) device, a Universal Serial Bus (USB), a computing system, a medical system, or a communication system, in which at least one semiconductor memory device 1100 is provided.

The semiconductor memory device 1100 may be a nonvolatile memory device (e.g., a NAND flash memory device). The semiconductor memory device 1100 may include a first structure 1100F and a second structure 1100S on the first structure 1100F. In an embodiment, the first structure 1100F may be disposed near the second structure 1100S.

The first structure 1100F may be a peripheral circuit structure, which includes a decoder circuit 1110, a page buffer 1120, and a logic circuit 1130. The second structure 1100S may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of the lower transistors LT1 and LT2 and the number of the upper transistors UT1 and UT2 may be variously changed, according to embodiments.

In an embodiment, the upper transistors UT1 and UT2 may include at least one string selection transistor, and the lower transistors LT1 and LT2 may include at least one ground selection transistor. The gate lower lines LL1 and LL2 may be used as gate electrodes of the lower transistors LT1 and LT2, respectively. The word lines WL may be used as gate electrodes of the memory cell transistors MCT, and the gate upper lines UL1 and UL2 may be used as gate electrodes of the upper transistors UT1 and UT2, respectively.

In an embodiment, the lower transistors LT1 and LT2 may include a lower erase control transistor LT1 and a ground selection transistor LT2, which are connected in series. The upper transistors UT1 and UT2 may include a string selection transistor UT1 and an upper erase control transistor UT2, which are connected in series. At least one of the lower and upper erase control transistors LT1 and UT1 may be used to perform an erase operation of erasing data in the memory cell transistors MCT using a Gate-Induced Drain Leakage GIDL phenomenon.

The common source line CSL, the first and second gate lower lines LL1 and LL2, the word lines WL, and the first and second gate upper lines UL1 and UL2 may be electrically connected to the decoder circuit 1110 through first connection lines 1115, which are extended from the first structure 1100F to the second structure 1100S. The bit lines BL may be electrically connected to the page buffer 1120 through second connection lines 1125, which are extended from the first structure 1100F to the second structure 1100S.

In the first structure 1100F, the decoder circuit 1110 and the page buffer 1120 may be configured to perform a control operation on at least one transistor that is selected from the memory cell transistors MCT. The decoder circuit 1110 and the page buffer 1120 may be controlled by the logic circuit 1130. The semiconductor memory device 1100 may communicate with the controller 1200 through an input/output pad 1101 electrically connected to the logic circuit 1130. The input/output pad 1101 may be electrically connected to the logic circuit 1130 through an input/output connection line 1135, which is provided in the first structure 1100F and is extended into the second structure 1100S.

In one embodiment, the first structure 1100F may include a voltage generator. The voltage generator may generate a program voltage, a read voltage, a pass voltage, a verification voltage, and so forth, which are needed to operate the memory cell strings CSTR. Here, the program voltage may be a relatively high voltage (e.g., 20V to 40V), compared with the read voltage, the pass voltage, and the verification voltage.

In an embodiment, the first structure 1100F may include high voltage transistors and low voltage transistors. The decoder circuit 1110 may include pass transistors which are connected to the word lines WL of the memory cell strings CSTR. The pass transistors of the decoder circuit 1110 may include high-voltage transistors which can stand a high voltage (e.g., the program voltage) applied to the word lines WL during a programming operation). The page buffer 1120 may also include high-voltage transistors which can stand the high voltage.

As shown in FIG. 1, the controller 1200 may include a processor 1210, a NAND controller 1220, and a host interface 1230. In an embodiment, the electronic system 1000 may include a plurality of semiconductor memory devices 1100, and in this case, the controller 1200 may control the semiconductor memory devices 1100.

The processor 1210 may control overall operations of the electronic system 1000 including the controller 1200. The processor 1210 may be operated based on a specific firmware and may control the NAND controller 1220 to access the semiconductor memory device 1100. The NAND controller 1220 may include a NAND interface 1221, which is used to communicate with the semiconductor memory device 1100. The NAND interface 1221 may be used to transmit and receive control commands for controlling the semiconductor memory device 1100 and data to be written in or read from the memory cell transistors MCT of the semiconductor memory device 1100. The host interface 1230 may be configured to allow for communication between the electronic system 1000 and an external host. When a control command is received from an external host through the host interface 1230, the processor 1210 may control the semiconductor memory device 1100 in response to the control command.

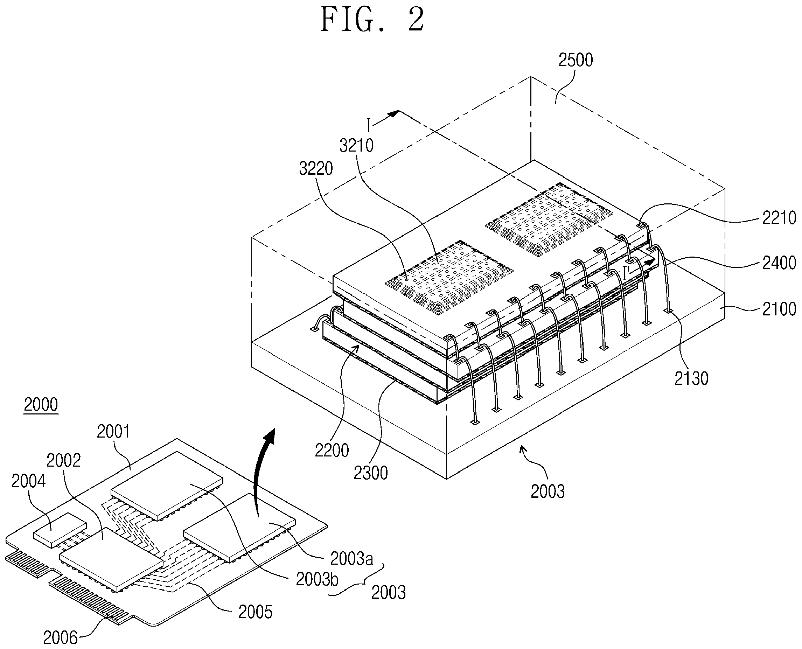

FIG. 2 is a perspective view schematically illustrating an electronic system including a semiconductor device according to an embodiment of the present disclosure. In FIG. 2, an electronic system 2000 according to an embodiment of the present disclosure may include a main substrate 2001 and a controller 2002, at least one semiconductor package 2003, and a DRAM 2004, which are mounted on the main substrate 2001. The semiconductor package 2003 and the DRAM 2004 may be connected to the controller 2002 via interconnection patterns 2005, which are formed in the main substrate 2001.

The main substrate 2001 may include a connector 2006, which includes a plurality of pins coupled to an external host. In the connector 2006, the number and arrangement of the pins may depend on a communication interface between the electronic system 2000 and the external host. In an embodiment, the electronic system 2000 may communicate with the external host, in accordance with one of interfaces, such as Universal Serial Bus (USB), Peripheral Component Interconnect Express (PCI-Express), Serial Advanced Technology Attachment (SATA), Universal Flash Storage (UFS) M-Phy, or the like. In an embodiment, the electronic system 2000 may be driven by a power, which is supplied from the external host through the connector 2006. The electronic system 2000 may further include a Power Management Integrated Circuit (PMIC) that is configured to separately supply an electric power, which is supplied from the external host, to the controller 2002 and the semiconductor package 2003. The controller 2002 may be configured to control a writing or reading operation on the semiconductor package 2003 and to improve an operation speed of the electronic system 2000.

The DRAM 2004 may be a buffer memory that is configured to relieve technical difficulties caused by a difference in speed between the semiconductor package 2003, which serves as a data storage device, and an external host. In an embodiment, the DRAM 2004 in the electronic system 2000 may serve as a cache memory and may be used as a storage space, which is used to temporarily store data during a control operation on the semiconductor package 2003. In a case where the electronic system 2000 includes the DRAM 2004, the controller 2002 may further include a DRAM controller for controlling the DRAM 2004, in addition to a NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200 on the package substrate 2100, adhesive layers 2300 respectively disposed on bottom surfaces of the semiconductor chips 2200, a connection structure 2400 electrically connecting the semiconductor chips 2200 to the package substrate 2100, and a molding layer 2500 disposed on the package substrate 2100 to cover the semiconductor chips 2200 and the connection structure 2400.

The package substrate 2100 may be a printed circuit board including upper pads 2130. Each of the semiconductor chips 2200 may include an input/output pad 2210. The input/output pad 2210 may correspond to the input/output pad 1101 of FIG. 1. Each of the semiconductor chips 2200 may include stacks 3210 and vertical structures 3220. Each of the semiconductor chips 2200 may include a semiconductor memory device, which will be described below, according to an embodiment of the present disclosure.

In an embodiment, the connection structure 2400 may include a bonding wire electrically connecting the input/output pad 2210 to the upper pads 2130. Thus, in each of the first and second semiconductor packages 2003a and 2003b, the semiconductor chips 2200 may be electrically connected to each other in a bonding wire manner and may be electrically connected to the upper pads 2130 of the package substrate 2100. In an embodiment, the semiconductor chips 2200 in each of the first and second semiconductor packages 2003a and 2003b may be electrically connected to each other by a connection structure including Through Silicon Vias (TSVs), not by the connection structure 2400 provided in the form of bonding wires.

In an embodiment, the controller 2002 and the semiconductor chips 2200 may be included in a single package. In an embodiment, the controller 2002 and the semiconductor chips 2200 may be mounted on a separate interposer substrate, which is prepared regardless of the main substrate 2001, and may be connected to each other through interconnection lines, which are provided in the interposer substrate.

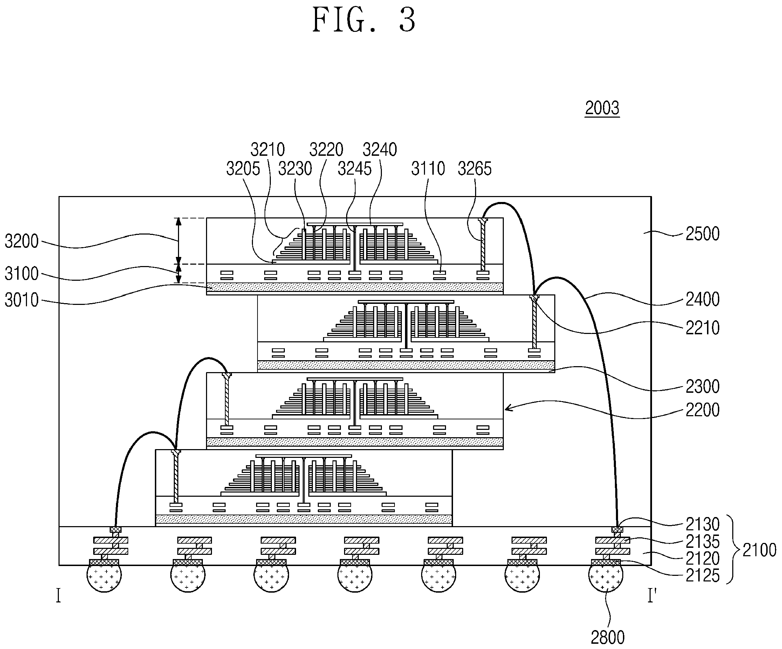

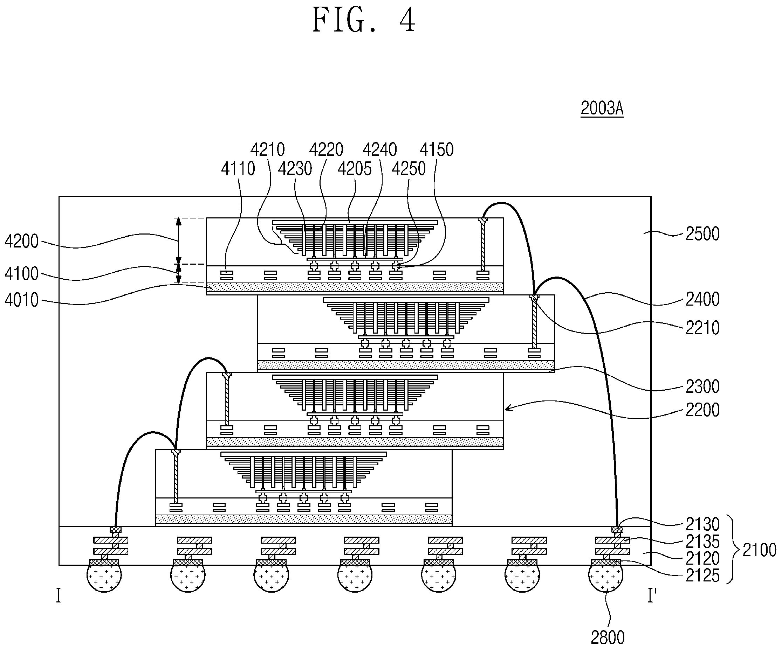

FIGS. 3 and 4 are sectional views schematically illustrating semiconductor packages according to an embodiment of the present disclosure. FIGS. 3 and 4 are sectional views, which are taken along a line I-I' of FIG. 2 to illustrate two different examples of the semiconductor package of FIG. 2.

In FIG. 3, in the semiconductor package 2003, the package substrate 2100 may be a printed circuit board. The package substrate 2100 may include a package substrate body portion 2120, the upper pads 2130 (the upper pads 2130 of FIG. 2), which are disposed on a top surface of the package substrate body portion 2120, lower pads 2125, which are disposed on or exposed through a bottom surface of the package substrate body portion 2120, and internal lines 2135, which are provided in the package substrate body portion 2120 to electrically connect the upper pads 2130 to the lower pads 2125.

The upper pads 2130 may be electrically connected to the connection structures 2400. The lower pads 2125 may be connected to the interconnection patterns 2005 of the main substrate 2001 of the electronic system 2000 through conductive connecting portions 2800, as shown in FIG. 2.

Each of the semiconductor chips 2200 may include a semiconductor substrate 3010, a first structure 3100, and a second structure 3200, which are sequentially stacked on the semiconductor substrate 3010. The first structure 3100 may include a peripheral circuit region, in which peripheral lines 3110 are provided. The second structure 3200 may include a first source structure 3205, a stack 3210 on the first source structure 3205, the vertical structures 3220 and separation structures penetrating the stack 3210, bit lines 3240 electrically connected to the vertical structures 3220, and cell contact plugs 3235 electrically connected to the word lines WL (e.g., of FIG. 1) of the stack 3210. Each of the first structure 3100 and the second structure 3200 and the semiconductor chips 2200 may further include separation structures to be described below.

Each of the semiconductor chips 2200 may include penetration lines 3245, which are electrically connected to the peripheral lines 3110 of the first structure 3100 and are extended into the second structure 3200. The penetration line 3245 may be disposed outside the stack 3210, and in an embodiment, the penetration line 3245 may be provided to further penetrate the stack 3210. Each of the semiconductor chips 2200 may further include the input/output pads 2210 (e.g., the input/output pads 2210 of FIG. 2), which are electrically connected to the peripheral lines 3110 of the first structure 3100.

In FIG. 4, in a semiconductor package 2003A, each of the semiconductor chips 2200 may include a semiconductor substrate 4010, a first structure 4100 on the semiconductor substrate 4010, and a second structure 4200, which is provided on the first structure 4100 and is bonded with the first structure 4100 in a wafer bonding manner.

The first structure 4100 may include a peripheral circuit region, in which a peripheral line 4110 and first junction structures 4150 are provided. The second structure 4200 may include a second source structure 4205, a stack 4210 between the first structure 4100 and the second source structure 4205, vertical structures 4220 and a separation structure penetrating the stack 4210, and second junction structures 4250, which are electrically and respectively connected to the vertical structures 4220 and the word lines WL (e.g., the word lines WL FIG. 1) of the stack 4210. For example, the second junction structures 4250 may be electrically and respectively connected to the vertical structures 4220 and the word lines WL (e.g., the word lines WL of FIG. 1) through bit lines 4240, which are electrically connected to the vertical structures 4220, and cell contact plugs 4235, which are electrically connected to the word lines WL (e.g., the word lines WL of FIG. 1). The first junction structures 4150 of the first structure 4100 may be in contact with and bonded to the second junction structures 4250 of the second structure 4200. The bonded portions of the first junction structure 4150 and the second junction structure 4250 may be formed of or include, for example, copper (Cu).

Each of the first structure 4100, the second structure 4200, and the semiconductor chips 2200 may further include a source structure in an embodiment to be described below. Each of the semiconductor chips 2200 may further include the input/output pads 2210 (e.g., the input/output pads 2210 of FIG. 2), which are electrically connected to the peripheral lines 4110 of the first structure 4100.

The semiconductor chips 2200 of FIG. 3 or 4 may be electrically connected to each other by the connection structures 2400, which are provided in the form of bonding wires. However, in an embodiment, semiconductor chips, which are provided in the same semiconductor package as the semiconductor chips 2200 of FIG. 3 or 4, may be electrically connected to each other by a connection structure including TSVs.

The first structure 3100 or 4100 of FIG. 3 or 4 may correspond to a peripheral circuit structure in an embodiment to be described below, and the second structure 3200 or 4200 of FIG. 3 or 4 may correspond to a cell array structure in an embodiment to be described below.

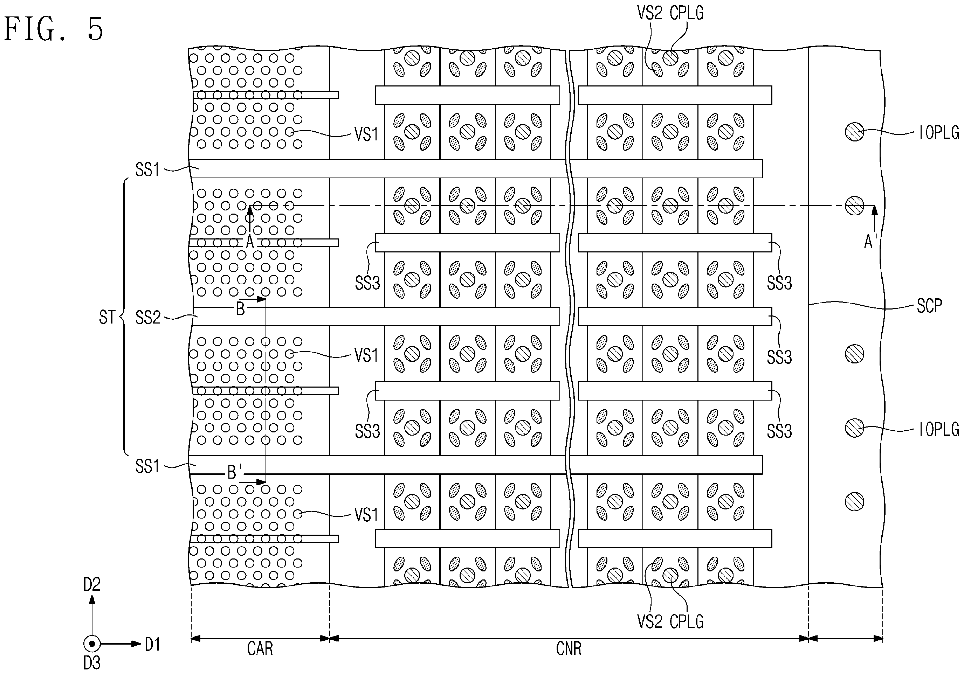

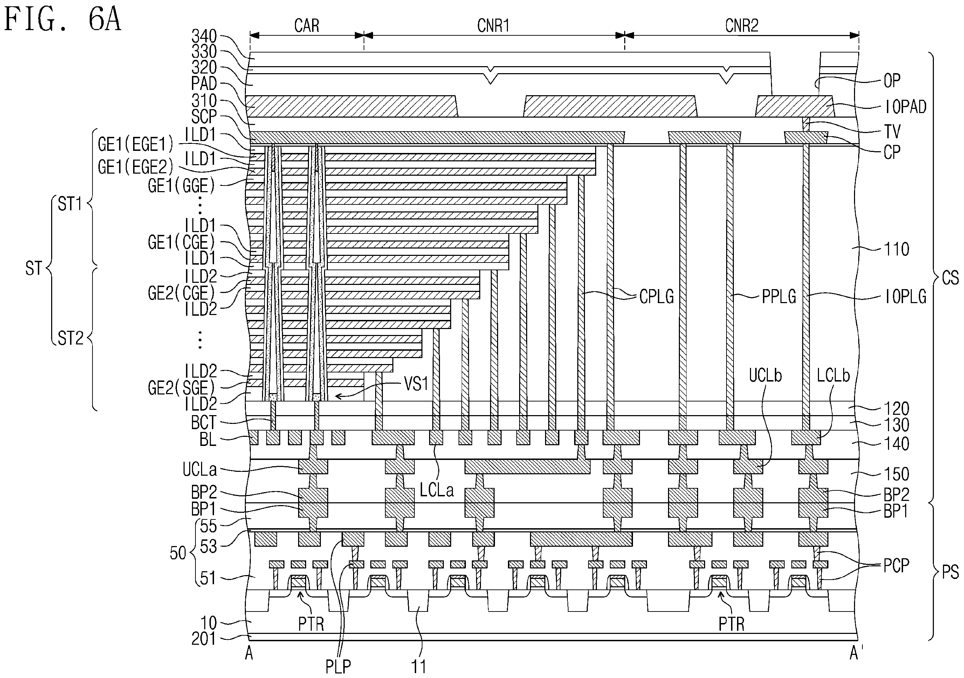

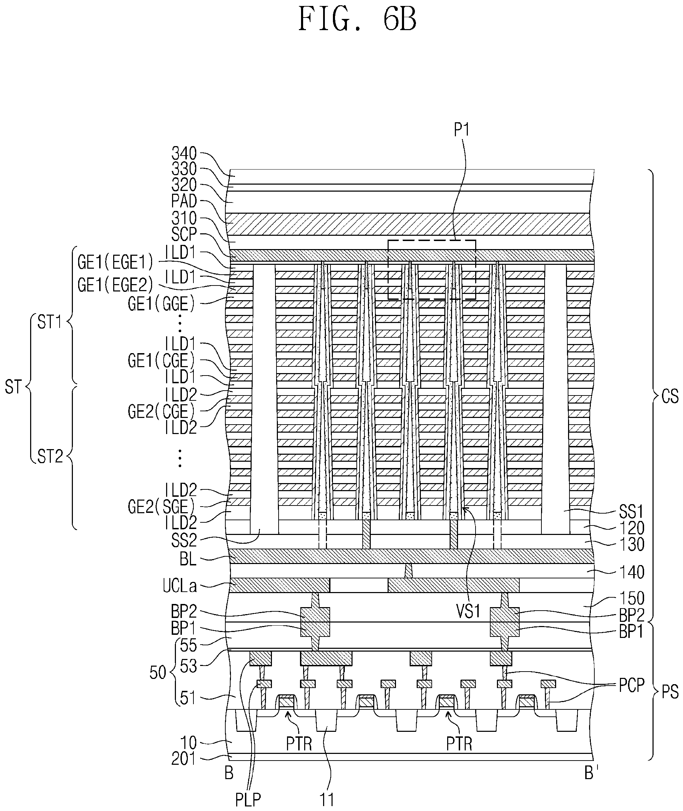

FIG. 5 is a plan view illustrating a semiconductor memory device according to an embodiment of the present disclosure. FIG. 6A is a sectional view, which is taken along a line A-A' of FIG. 5 to illustrate a semiconductor memory device according to an embodiment of the present disclosure. FIG. 6B is a sectional view, which is taken along a line B-B' of FIG. 5 to illustrate a semiconductor memory device according to an embodiment of the present disclosure.

In FIGS. 5, 6A, and 6B, a semiconductor memory device according to an embodiment of the present disclosure may include a first substrate 10, a peripheral circuit structure PS on the first substrate 10, and a cell array structure CS on the peripheral circuit structure PS.

In an embodiment, since the cell array structure CS is placed on the peripheral circuit structure PS, a cell capacity per unit area in the semiconductor memory device may be increased. In addition, the peripheral circuit structure PS and the cell array structure CS may be separately fabricated and then may be coupled to each other. In this case, it may be possible to prevent peripheral circuits PTR from being damaged by several thermal treatment processes. Accordingly, the semiconductor memory device may have improved electrical and reliability characteristics.

The peripheral circuit structure PS may include the peripheral circuits PTR, which are integrated on the front surface of the first substrate 10 and are used to control the memory cell array, peripheral contact plugs 31, peripheral circuit lines 33, which are electrically connected to the peripheral circuits PTR through the peripheral contact plugs 31, first bonding pads BP1, which are electrically connected to the peripheral circuit lines 33, and a lower insulating layer 50, which is provided to enclose them.

In an embodiment, the first substrate 10 may be a silicon substrate, a silicon-germanium substrate, a germanium substrate, or a structure including a single-crystalline silicon substrate and a single-crystalline epitaxial layer grown therefrom. The first substrate 10 may have a top surface that is parallel to two different directions (e.g., a first direction D1 and a second direction D2) and is perpendicular to a third direction D3. Here, the first to third directions D1, D2, and D3 may be orthogonal to each other. A device isolation layer 11 may be provided in the first substrate 10. The device isolation layer 11 may define an active region of the first substrate 10,

The peripheral circuits PTR may be the row and column decoders, the page buffer, and the control circuit described with reference to FIG. 1. The peripheral circuits PTR may include NMOS and PMOS transistors. The transistors constituting the peripheral circuits PTR may be provided on the active region of the first substrate 10. Peripheral circuit lines PLP may be electrically connected to the peripheral circuits PTR through peripheral contact plugs PCP.

In an embodiment, widths of the peripheral contact plugs PCP in the first or second direction D1 or D2 may increase as a height in the third direction D3 increases. The peripheral contact plugs 31 and the peripheral circuit lines PLP may be formed of or include at least one of conductive materials (e.g., metallic materials).

The lower insulating layer 50 may include a plurality of vertically-stacked insulating layers. For example, the lower insulating layer 50 may include a silicon oxide layer, a silicon nitride layer, a silicon oxynitride layer, and/or a low-k dielectric layer.

In an embodiment, the lower insulating layer 50 may include a first lower insulating layer 51, a second lower insulating layer 55, and an etch stop layer 53 between the first lower insulating layer 51 and the second lower insulating layer 55. The etch stop layer 53 may be formed of or include an insulating material different from the first lower insulating layer 51 and the second lower insulating layer 55 and may cover the top surfaces of the uppermost ones of the peripheral circuit lines PLP. In addition, a surface insulating layer 201 may be provided on the bottom surface of the first substrate 10.

The first bonding pads BP1 may be disposed in the uppermost one of the lower insulating layers 50. The lower insulating layer 50 may not cover top surfaces of the first bonding pads BP1. A top surface of the uppermost one of the lower insulating layers 50 may be substantially coplanar with the top surfaces of the first bonding pads BP1. The first bonding pads BP1 may be electrically connected to the peripheral circuits PTR through the peripheral circuit lines PLP and the peripheral contact plugs PCP.

The cell array structure CS may be provided on the peripheral circuit structure PS. The cell array structure CS of the semiconductor memory device may include a cell array region CAR and first and second connection regions CNR1 and CNR2, and here, the first connection region CNR1 may be placed between the cell array region CAR and the second connection region CNR2 in the first direction D1.

The cell array structure CS may include a memory cell array, in which memory cells are three-dimensionally arranged. The cell array structure CS may include a source conductive pattern SCP, a stack ST, first and second vertical structures VS1 and VS2, bit lines BL, cell contact plugs CPLG, peripheral contact plugs PPLG, and input/output contact plugs IOPLG.

The cell array structure CS may include a plurality of stacks ST. When viewed in the plan view of FIG. 5, the stacks ST may be extended in the first direction D1 and may be spaced apart from each other in the second direction D2. Hereinafter, just one stack ST will be described, for brevity's sake, but the others of the stacks ST may also have substantially the same features as described below. The stack ST may include conductive patterns GE1 and GE2 and interlayer insulating layers ILD1 and ILD2, which are alternately stacked in the third direction D3 (e.g., a vertical direction) that is perpendicular to the first and second directions D1 and D2.

In an embodiment, the conductive patterns GE1 and GE2 may include first and second erase gate patterns EGE1 and EGE2 adjacent to the source conductive pattern SCP, a ground selection gate pattern GGE on the second erase gate pattern EGE2, a plurality of cell gate patterns CGE stacked on the ground selection gate pattern GGE, and a string selection gate pattern SGE on the uppermost one of the cell gate patterns CGE.

The erase control gate patterns EGE1 and EGE2 may be adjacent to the source conductive pattern SCP, may be configured to cause a GIDL phenomenon in the memory cell array, and may be used as gate patterns of the erase control transistors LT1 (e.g., LT1 of FIG. 1) controlling the erase operation. The ground selection gate patterns GGE may be used as the gate patterns of the ground selection transistors LT2 (e.g., LT2 of FIG. 1) controlling an electric connection between the common source line CSL (e.g., CSL of FIG. 1) and the vertical channel. The cell gate patterns CGE may be used as the word lines WL of the memory cell transistors MCT (e.g., MCT of FIG. 1). The uppermost one of the string selection gate patterns SGE may be used as the gate pattern of the string selection transistor UT1 or UT2 (e.g., UT1 or UT2 of FIG. 1) controlling an electric connection between the bit line BL and the first vertical structures VS1.

The conductive patterns GE1 and GE2 of the stack ST may be stacked to have an inverted staircase structure in the first connection region CNR1. For example, lengths of the conductive patterns GE1 and GE2 in the first direction D1 may increase as a distance from the peripheral circuit structure PS increases.

Each of the conductive patterns GE1 and GE2 may include a pad portion, which is provided in the first connection region CNR1. The pad portions of the conductive patterns GE1 and GE2 may be located at different positions in horizontal and vertical directions. The cell contact plugs CPLG may be respectively coupled to the pad portions of the conductive patterns GE1 and GE2.

In an embodiment, the stack ST may include a first stack ST1 and a second stack ST2 on the first stack ST1. The first stack ST1 may include first interlayer insulating layers ILD1 and first conductive patterns GE1, which are alternately stacked on top of another, and the second stack ST2 may include second interlayer insulating layers ILD2 and second conductive patterns GE2, which are alternately stacked on top of another.

The second stack ST2 may be disposed between the first stack ST1 and the peripheral circuit structure PS. More specifically, the second stack ST2 may be provided on a bottom surface of the lowermost one of the first interlayer insulating layers ILD1 of the first stack ST1. The uppermost one of the second interlayer insulating layers ILD2 of the second stack ST2 may be in contact with the lowermost one of the first interlayer insulating layers ILD1 of the first stack ST1, but the present disclosure is not limited to this example. For example, a single insulating layer may be provided between the uppermost one of the second conductive patterns GE2 of the second stack ST2 and the first conductive patterns GE1 of the first stack ST1.

The lowermost one of the second conductive patterns GE2 of the second stack ST2 may have the shortest length in the first direction D1, and the uppermost one of the first conductive patterns GE1 of the first stack ST1 may have the longest length in the first direction D1.

In an embodiment, the first and second conductive patterns GE1 and GE2 may be formed of or include at least one of doped semiconductor materials (e.g., doped silicon), metallic materials (e.g., tungsten, molybdenum, nickel, copper, and aluminum), conductive metal nitride materials (e.g., titanium nitride and tantalum nitride), or transition metals (e.g., titanium and tantalum). The first and second interlayer insulating layers ILD1 and ILD2 may be formed of or include at least one of silicon oxide, silicon nitride, silicon oxynitride, and/or low-k dielectric materials. For example, the first and second interlayer insulating layers ILD1 and ILD2 may be formed of or include High Density Plasma (HDP) oxide or Tetraethylorthosilicate (TEOS).

In an embodiment, the semiconductor memory device may be a vertical-type NAND flash memory device, and in this case, the first and second conductive patterns GE1 and GE2 of the stack ST may be used as the gate lower lines LL1 and LL2, the word lines WL, and the gate upper lines UL1 and UL2 described with reference to FIG. 1.

A planarization insulating layer 110 may be provided to cover staircase end portions (i.e., the pad portions) of the stack ST. The planarization insulating layer 110 may have a substantially flat top surface. The planarization insulating layer 110 may include a single insulating layer or a plurality of insulating layers stacked. The planarization insulating layer 110 may have a substantially flat top surface and a substantially flat bottom surface. The top surface of the planarization insulating layer 110 may be substantially coplanar with a top surface of the uppermost one of the interlayer insulating layers ILD1 of the stack ST, and the bottom surface of the planarization insulating layer 110 may be substantially coplanar with a bottom surface of the lowermost one of the interlayer insulating layers ILD2 of the stack ST.

The source conductive pattern SCP may be disposed on the uppermost one of the first interlayer insulating layers ILD1 of the first stack ST1. The source conductive pattern SCP may have a uniform thickness and may have a substantially flat top surface. In the cell array region CAR and the first connection region CNR1, the source conductive pattern SCP may be extended parallel to the stack ST or in the first direction D1. When measured in the first direction D1, a length of the source conductive pattern SCP may be larger than a length of the uppermost one of the first conductive patterns GE1 of the first stack ST1.

The source conductive pattern SCP may be formed of or include at least one of, for example, doped semiconductor materials (e.g., doped silicon), metallic materials (e.g., tungsten, molybdenum, nickel, copper, and aluminum), conductive metal nitrides (e.g., titanium nitride and tantalum nitride), or transition metals (e.g., titanium and tantalum). In an embodiment, the source conductive pattern SCP may be formed of or include at least one of metallic materials (e.g., tungsten).

The source conductive pattern SCP may correspond to the source structures (the first source structure 3205 and the second source structure 4205 of FIGS. 3 and 4). In the cell array region CAR, the first vertical structures VS1 may be provided to penetrate the stack ST and may be connected to the source conductive pattern SCP. The first vertical structures VS 1 may be arranged in a specific direction or in a zigzag shape, when viewed in a plan view. The second vertical structures VS2 may penetrate the stack ST in the first connection region CNR1.

In the first connection region CNR1, the second vertical structures VS2 may be provided to penetrate the end portions (i.e., the pad portions) of the first and second conductive patterns GE1 and GE2. The second vertical structures VS2 may have substantially the same structure as the first vertical structures VS1 and may be formed of or include the same material as the first vertical structures VS1.

When viewed in a plan view, shapes and sizes of the second vertical structures VS2 may be different from those of the first vertical structures VS1. Top surfaces of the second vertical structures VS2 may have various shapes (e.g., circular, elliptical, and bar shapes). Each of the second vertical structures VS2 may be disposed to enclose a corresponding one of the cell contact plugs CPLG. In a case where the second vertical structures VS2 have elliptical top surfaces, the second vertical structures VS2 in each pad portion may be disposed such that directions of the long axes thereof are different from each other. In an embodiment, a plurality of the second vertical structures VS2 may be provided between adjacent ones of the cell contact plugs CPLG.

In an embodiment, each of the first vertical structures VS1 may be provided in a vertical channel hole penetrating the stack ST. In an embodiment, the vertical channel hole may include first vertical channel holes, which are formed to penetrate the first stack ST1, and second vertical channel holes, which are formed to penetrate the second stack ST2 and are connected to the first vertical channel holes.

Each of the first vertical structures VS1 may include a first vertical extended portion in the first vertical channel hole and a second vertical extended portion in the second vertical channel hole. The first and second vertical extended portions may be a single structure that is continuously extended without any observable interface. Here, the first vertical extended portion may have a side surface, and a slope of the side surface is substantially constant from top to bottom. Similarly, the second vertical extended portion may have a side surface whose slope is substantially constant from top to bottom. In other words, a width of each of the first and second vertical extended portions in the first or second direction D1 or D2 may decrease as a distance from the first substrate 10 increases. The first and second vertical extended portions may have different diameters at a level of the interface therebetween. For example, the first and second vertical extended portions may be provided to form a stepwise structure near the interface therebetween.

However, the present disclosure is not limited to this example. Each of the first vertical structures VS1 may, for example, include three or more vertical extended portions, which are provided to form the stepwise structure at two or more levels, unlike that illustrated in the drawings. In an embodiment, each of the first vertical structures VS1 may be provided to have a flat side surface without any stepwise portion.

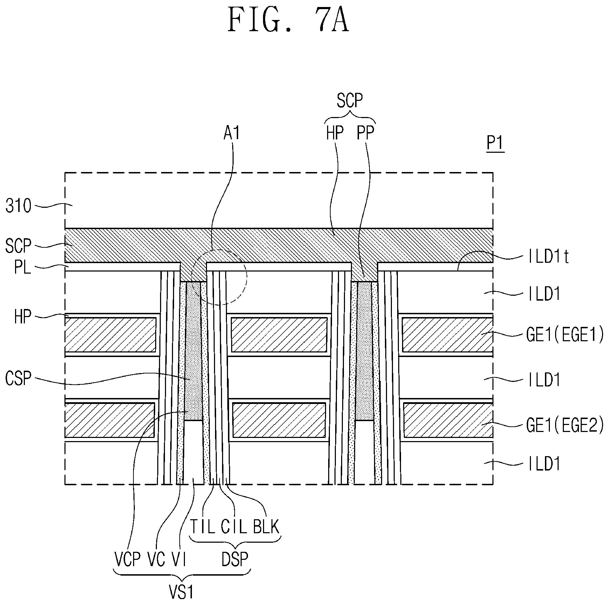

A detailed structure of the first vertical structure VS1 will be described in more detail with reference to FIGS. 7A to 7F, 8A to 8D, and 9A and 9B.

First, second, and third separation structures SS1, SS2, and SS3 may be provided to penetrate the planarization insulating layer 110 and the stack ST. Each of the first, second, and third separation structures SS1, SS2, and SS3 may include an insulating layer covering a side surface of the stack ST. Each of the first, second, and third separation structures SS1, SS2, and SS3 may have a single- or multi-layered structure.

The first separation structures SS1 may be extended from the cell array region CAR to the first connection region CNR1 in the first direction D1 and parallel to each other and may be spaced apart from each other in the second direction D2 crossing the first direction D1.

The second separation structure SS2 may be provided in the cell array region CAR to penetrate the stack ST. The second separation structure SS2 may be disposed between the first separation structures SS1. When measured in the first direction D1, a length of the second separation structure SS2 may be smaller than a length of the first separation structure SS1. Alternatively, a plurality of second separation structures SS2 may be provided between the first separation structures SS1.

In the first connection region CNR1, the third separation structures SS3 may be spaced apart from the first and second separation structures SS1 and SS2 in the first direction D1 and may be provided to penetrate the planarization insulating layer 110 and the stack ST. The third separation structures SS3 may be extended in the first direction D1. The third separation structures SS3 may be spaced apart from each other in the first direction D1 and the second direction D2.

A first interlayer insulating layer 120, a second interlayer insulating layer 130, a third interlayer insulating layer 140, and a fourth interlayer insulating layer 150 may be disposed between the peripheral circuit structure PS and the stack ST and between the peripheral circuit structure PS and the planarization insulating layer 110. The first interlayer insulating layer 120, the second interlayer insulating layer 130, the third interlayer insulating layer 140, and the fourth interlayer insulating layer 150 may be sequentially stacked on the planarization insulating layer 110. The first interlayer insulating layer 120 may cover bottom surfaces of the first and second vertical structures VS1 and VS2. The first interlayer insulating layer 120, the second interlayer insulating layer 130, the third interlayer insulating layer 140, and the fourth interlayer insulating layer 150 may be formed of or include at least one of silicon oxide, silicon nitride, silicon oxynitride, and/or low-k dielectric materials.

The bit lines BL, lower conductive lines LCLa and LCLb, upper conductive lines UCLa and UCLb, and second bonding pads BP2 may be disposed in the first interlayer insulating layer 120, the second interlayer insulating layer 130, the third interlayer insulating layer 140, and the fourth interlayer insulating layer 150.

The bit lines BL may be disposed on the second interlayer insulating layer 130 in the cell array region CAR and may be extended in the second direction D2 to cross the stack ST, as shown in FIGS. 6A and 6B. The bit lines BL may be electrically connected to the first vertical structures VS1 through bit line contact plugs BCT. A bit line conductive pad may be formed in a bottom end of the first vertical structure VS1, and the bit line contact plugs BCT may be in contact with the bit line conductive pad. The bit line conductive pad may be formed of or include at least one of undoped semiconductor materials, doped semiconductor materials, or conductive materials.

The cell contact plugs CPLG may be provided to penetrate the first interlayer insulating layer 120 and the planarization insulating layer 110 and may be coupled to the pad portions of the first and second conductive patterns GE1 and GE2, respectively. The smaller the distance to the cell array region CAR, the smaller the vertical lengths of the cell contact plugs CPLG. The cell contact plugs CPLG may have top surfaces that are substantially coplanar with each other.

In the second connection region CNR2, the peripheral contact plugs PPLG and the input/output contact plugs IOPLG may be provided to penetrate the first interlayer insulating layer 120 and the second interlayer insulating layer 130 and the planarization insulating layer 110 and may be coupled to upper conductive patterns UCP.

Each of the cell, peripheral, and input/output contact plugs CPLG, PPLG, and IOPLG may include a barrier metal layer, which is formed of or includes a conductive metal nitride (e.g., titanium nitride, tantalum nitride, and so forth), and a metal layer, which is formed of or includes a metallic material (e.g., tungsten, titanium, tantalum, and so forth).

First lower conductive lines LCLa may be disposed on the second interlayer insulating layer 130 of the first connection region CNR1 and may be coupled to the cell contact plugs CPLG through contact plugs.

Second lower conductive lines LCLb may be disposed on the second interlayer insulating layer 130 of the second connection region CNR2 and may be coupled to the peripheral and input/output contact plugs PPLG and IOPLG through contact plugs.

The first and second upper conductive lines UCLa and UCLb may be disposed on the third interlayer insulating layer 140. In the cell array region CAR, the first upper conductive lines UCLa may be electrically connected to the bit lines BL. In the first and second connection regions CNR1 and CNR2, the second upper conductive lines UCLb may be electrically connected to the second lower conductive lines LCLb.

The first and second lower conductive lines LCLa and LCLb and the first and second upper conductive lines UCLa and UCLb may be formed of or include at least one of, for example, metallic materials (e.g., tungsten, copper, and aluminum), conductive metal nitride materials (e.g., titanium nitride and tantalum nitride), or transition metals (e.g., titanium and tantalum). For example, the first and second lower conductive lines LCLa and LCLb may be formed of or include a material (e.g., tungsten) having relatively high electric resistivity, and the first and second upper conductive lines UCLa and UCLb may be formed of or include a material (e.g., copper) having relatively low electric resistivity.

The second bonding pads BP2 may be provided in the uppermost one of the interlayer insulating layers. The second bonding pads BP2 may be electrically connected to the first and second upper conductive lines UCLa and UCLb. The second bonding pads BP2 may be formed of or include aluminum, copper, or tungsten.

The second bonding pads BP2 may be electrically and physically connected to the first bonding pads BP1 by a bonding method. For example, the second bonding pads BP2 may be in direct contact with the first bonding pads BP1. The second bonding pads BP2 may be formed of or include the same metallic material as the first bonding pads BP1. The second bonding pads BP2 may have substantially the same as the first bonding pads BP1 in shape, width, or area.

Upper conductive patterns CP may be disposed on a top surface of the planarization insulating layer 110 and may be located at substantially the same level as the source conductive pattern SCP. The upper conductive patterns CP may be formed of or include the same conductive material as the source conductive pattern SCP. The input/output contact plug IOPLG may electrically be connected to an input/output pad through an upper via TV.

An upper insulating layer 310 may cover the source conductive pattern SCP and the upper conductive patterns UCP. Input/output pads IOPAD may be disposed on the upper insulating layer 310. A capping insulating layer 320 may be disposed on the upper insulating layer 310 to cover the input/output pads IOPAD.

The capping insulating layer 320 and a passivation layer 340 may be sequentially formed to cover the upper insulating layer 310. The capping insulating layer 320 may be, for example, a silicon nitride layer or a silicon oxynitride layer. The passivation layer 340 may be formed of or include polyimide-based materials (e.g., photo sensitive polyimide (PSPI)). The capping insulating layer 320 and the passivation layer 340 may have a pad opening OP, which is formed to expose a portion of the input/output pad IOPAD.

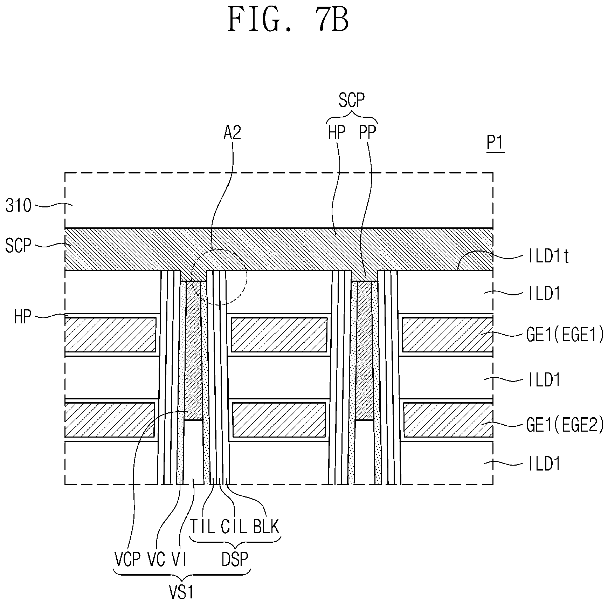

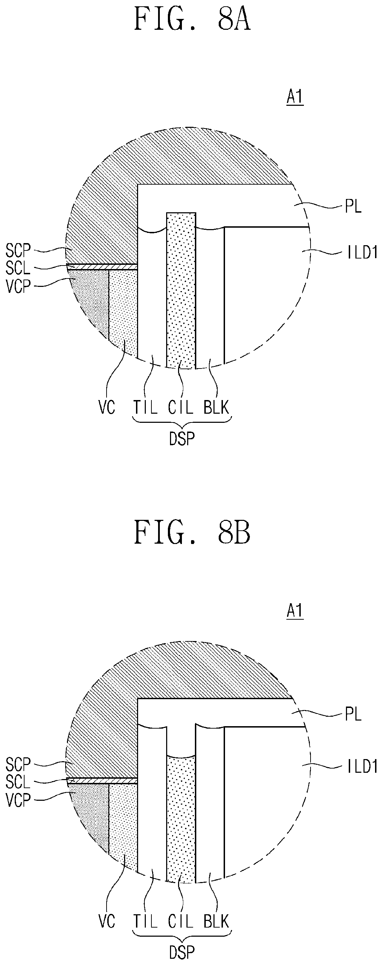

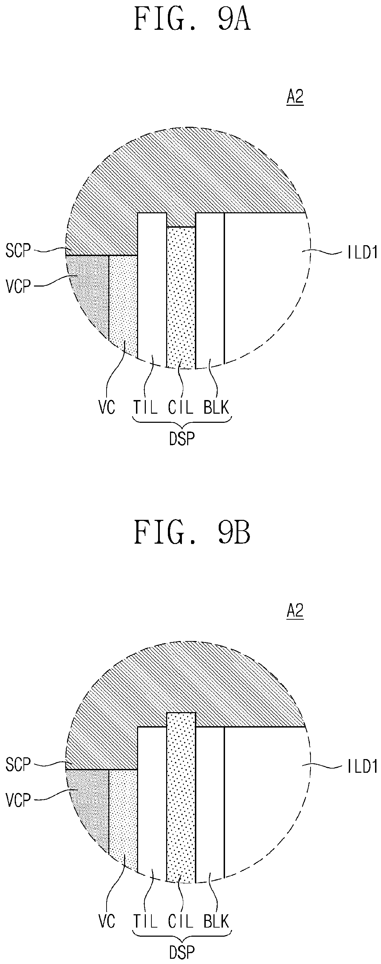

FIGS. 7A to 7F are enlarged sectional views illustrating a portion (e.g., `P1' of FIG. 6B) of a semiconductor memory device according to an embodiment of the present disclosure. FIGS. 8A to 8D are enlarged sectional views illustrating a portion `A1' of FIG. 7A. FIGS. 9A to 9B are enlarged sectional views illustrating a portion `A2' of FIG. 7B.

In FIG. 7A, the first vertical structures VS1 may be extended in the third direction D3, which is perpendicular to a top surface of the first substrate 10, to penetrate the stack ST and may be connected to the source conductive pattern SCP. The source conductive pattern SCP may include a horizontal portion HP, which is parallel to the stack ST, and protruding portions PP, which are extended from the horizontal portion HP in a vertical direction (i.e., the third direction D3). The source conductive pattern SCP may be formed of or include at least one of, for example, metallic materials (e.g., tungsten, copper, and aluminum), conductive metal nitride materials (e.g., titanium nitride and tantalum nitride), or transition metals (e.g., titanium and tantalum).

In an embodiment, an insulating reflection layer PL may be disposed between the source conductive pattern SCP and the uppermost layer (e.g., ILD1) of the interlayer insulating layers ILD1 and ILD2. The insulating reflection layer PL may have a substantially uniform thickness on the horizontal portion HP of the source conductive pattern SCP. In addition, the insulating reflection layer PL may cover a top surface of a data storage pattern DSP. In an embodiment, the insulating reflection layer PL may include a silicon nitride layer or a silicon oxynitride layer. Each of the first vertical structures VS1 may include a vertical channel pattern VC, a data storage pattern DSP, a vertical insulating pillar VI, and a vertical conductive pillar VCP.

The vertical channel pattern VC may be shaped like a hollow pipe or macaroni with opened top and bottom. The vertical channel pattern VC may have an inner side surface, which defines an internal space, and an outer side surface, which is adjacent to the stack ST. The vertical channel pattern VC may be provided to enclose an outer side surface of the vertical insulating pillar VI and an outer side surface of the vertical conductive pillar VCP.

The vertical channel pattern VC may be formed of or include at least one of semiconductor materials (e.g., silicon (Si) and germanium (Ge)). The vertical channel pattern VC, which includes the semiconductor material, may be used as channel patterns of the upper transistors UT1 and UT2, the memory cell transistors MCT, and the lower transistors LT1 and LT2 described with reference to FIG. 1.

The vertical channel pattern VC may be connected to the source conductive pattern SCP. The vertical channel pattern VC may be in contact with the protruding portion PP of the source conductive pattern SCP. A top surface of the vertical channel pattern VC may be located at a level lower than a top surface ILD1t of the uppermost one of the interlayer insulating layers ILD1.

The data storage pattern DSP may be extended in the third direction D3 to enclose the outer side surface of each of the vertical channel patterns VC. The data storage pattern DSP may be shaped like a pipe or macaroni with opened top and bottom. The data storage pattern DSP may be composed of one or more layers. In an embodiment, the data storage pattern DSP may be a data storing layer of a NAND FLASH memory device and may include a tunnel insulating layer TIL, a charge storing layer CIL, and a blocking insulating layer BLK, which are sequentially stacked on the side surface of the vertical channel pattern VC. In an embodiment, the charge storing layer CIL may be a trap insulating layer, a floating gate electrode, or an insulating layer with conductive nanodots.

The data storage pattern DSP may be provided to enclose a side surface of the protruding portion PP of the source conductive pattern SCP. A top surface of the data storage pattern DSP may be located at a level higher than the top surface of the vertical channel pattern VC. A portion of the insulating reflection layer PL may be disposed between the top surface of the data storage pattern DSP and the horizontal portion HP of the source conductive pattern SCP.

In FIGS. 8A and 8B, a top surface of the charge storing layer CIL in the data storage pattern DSP may be located at a level different from the top surface of the blocking insulating layer BLK and the top surface of the tunnel insulating layer TIL. As shown in FIG. 8A, the top surface of the charge storing layer CIL may be located at a level higher than the top surface of the blocking insulating layer BLK and the top surface of the tunnel insulating layer TIL.

Alternatively, as shown in FIG. 8B, the top surface of the charge storing layer CIL may be located at a level lower than the top surface of the blocking insulating layer BLK and the top surface of the tunnel insulating layer TIL. In addition, the blocking insulating layer BLK, the charge storing layer CIL, and the tunnel insulating layer TIL may have rounded top surfaces.

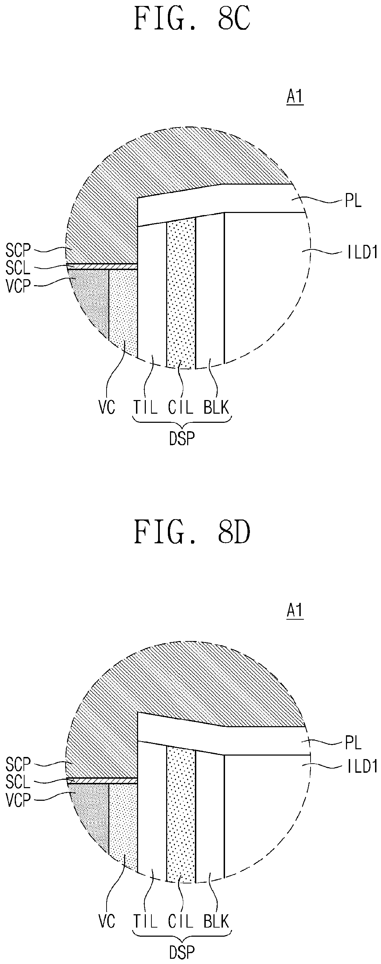

In FIGS. 8C and 8D, the data storage pattern DSP may have an inclined top surface. The vertical insulating pillar VI and the vertical conductive pillar VCP may be provided in the vertical channel pattern VC. A top surface of the vertical insulating pillar VI may be in contact with a bottom surface of the vertical conductive pillar VCP. The top surface of the vertical insulating pillar VI may be located at a level lower than a bottom surface of the lowermost conductive pattern GE1 (i.e., the first erase gate pattern EGE1). The vertical insulating pillar VI may be formed of or include at least one of, for example, silicon oxide, silicon nitride, silicon oxynitride and/or low-k dielectric materials.

The vertical conductive pillar VCP may be disposed between the vertical insulating pillar VI and the source conductive pattern SCP, when viewed in a vertical section. The vertical conductive pillar VCP may be used to electrically connect the vertical channel pattern VC to the source conductive pattern SCP.

The vertical conductive pillar VCP may be formed of or include a semiconductor material that is doped with dopants (e.g., phosphorus (P) or arsenic (As)) of a first conductivity type. As an example, the vertical conductive pillar VCP may be a polysilicon layer that is doped with n-type dopants. In this case, as shown in FIG. 8A, a metal silicide layer SCL (e.g., of tungsten silicide, cobalt silicide, or titanium silicide) may be interposed between the vertical conductive pillar VCP and the source conductive pattern SCP.

The vertical conductive pillar VCP may be enclosed by the uppermost one of the conductive patterns GE1 of the stack ST adjacent to the source conductive pattern SCP. For example, the first erase gate pattern EGE1, which is adjacent to the source conductive pattern SCP, may be provided to enclose the vertical conductive pillar VCP.

A top surface of the vertical conductive pillar VCP may be located at a level between top and bottom surfaces of the lowermost interlayer insulating layer ILD1. An interface between the vertical conductive pillar VCP and the vertical insulating pillar VI may be located at a level that is lower than a bottom surface of the lowermost conductive pattern GE1 (i.e., the first erase gate pattern EGE1). In addition, the interface between the vertical conductive pillar VCP and the vertical insulating pillar VI may be located at a level between top and bottom surfaces of the second erase gate pattern EGE2.

In an embodiment, since the vertical conductive pillar VCP is overlapped with the uppermost conductive pattern GE1 (i.e., the first erase gate pattern EGE1), it may be possible to induce a GIDL phenomenon more easily in an erase operation.

A horizontal insulating pattern HP may be provided between side surfaces of the conductive patterns GE1 and GE2 and the data storage pattern DSP. A horizontal insulating pattern HP may be extended from the side surfaces of the conductive patterns GE1 and GE2 to top and bottom surfaces of the conductive patterns GE1 and GE2.

According to the embodiment shown in FIG. 7B, the insulating reflection layer may be omitted. In this case, the source conductive pattern SCP may be in direct contact with a top surface of the uppermost one of the interlayer insulating layers ILD1 and the top surface of the data storage pattern DSP. In other words, as shown in FIGS. 9A and 9B, the source conductive pattern SCP may be in direct contact with top surfaces of the blocking insulating layer BLK, the charge storing layer CIL, and the tunnel insulating layer TIL.

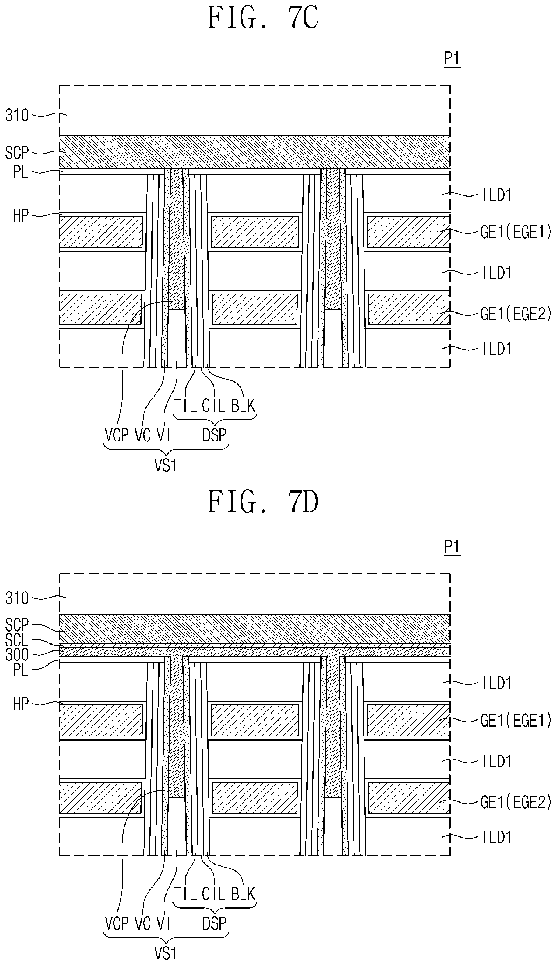

According to the embodiment shown in FIG. 7C, the top surfaces of the vertical channel pattern VC and the vertical conductive pillar VCP may be substantially coplanar with the top surface of the insulating reflection layer PL or the top surface of the uppermost one of the interlayer insulating layers ILD.

In FIG. 7D, a semiconductor layer 300 may be interposed between the source conductive pattern SCP and the insulating reflection layer PL, and the vertical conductive pillars VCP of the first vertical structures VS1 may be connected to the semiconductor layer 300.

The semiconductor layer 300 may be formed of or include a doped semiconductor material, and in this case, the metal silicide layer SCL may be disposed between the semiconductor layer 300 and the source conductive pattern SCP.

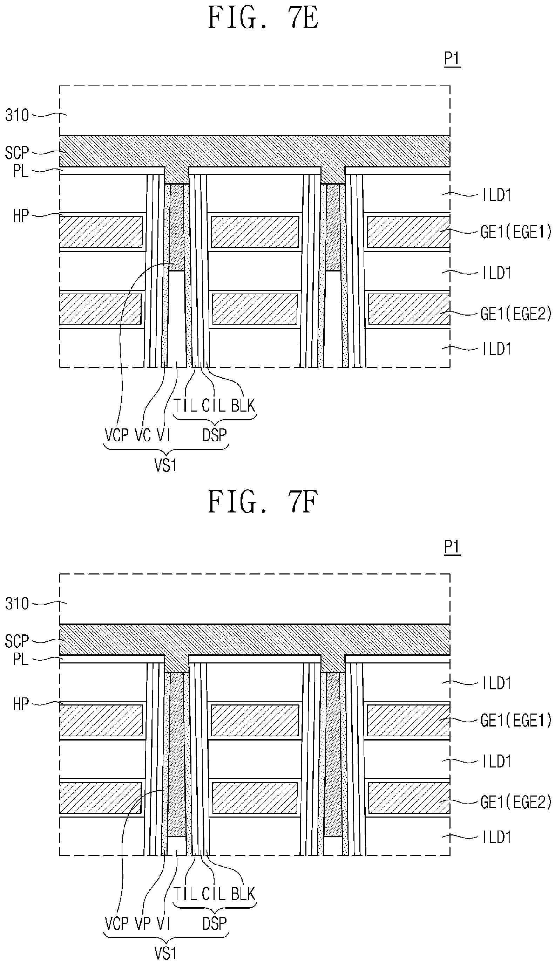

In FIG. 7E, top surfaces of the vertical conductive pillars VCP of the first vertical structures VS1 may be located at a level between top and bottom surfaces of the uppermost one of the interlayer insulating layers. Bottom surfaces of the vertical conductive pillars VCP may be located at a level between a bottom surface of the first erase gate pattern EGE1 and a top surface of the second erase gate pattern EGE2. In this case, the second erase gate pattern EGE2 may be used as a dummy gate.

In FIG. 7F, the bottom surfaces of the vertical conductive pillars VCP may be located at a level lower than a bottom surface of the second erase gate pattern EGE2. In other words, the first and second erase gate patterns EGE1 and EGE2 may be provided to enclose the vertical conductive pillars VCP.

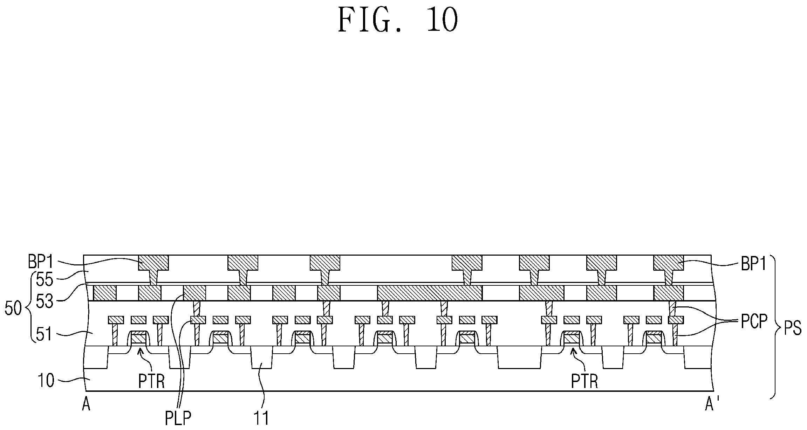

FIGS. 10 to 15 are sectional views, which are taken along the line A-A' of FIG. 5 to illustrate a method of fabricating a semiconductor memory device according to an embodiment of the present disclosure. In FIG. 10, the peripheral circuit structure PS, which includes the peripheral circuits PTR formed on the first substrate 10, may be formed.

The formation of the peripheral circuit structure PS may include forming the device isolation layer 11 to define an active region in the first substrate 10, forming the peripheral circuits PTR on the active region of the first substrate 10, and forming the peripheral contact plugs PCP, the peripheral circuit lines PLP, and the first bonding pads BP1, which are electrically connected to the peripheral circuits PTR, and forming a lower insulating layer 50 to cover them.

The first substrate 10 may be formed of or include at least one of Silicon (Si), Germanium (Ge), Silicon Germanium (SiGe), Gallium Arsenic (GaAs), Indium Gallium Arsenic (InGaAs), Aluminum Gallium Arsenic (AlGaAs), or compounds thereof.

Row and column decoders, page buffers, and control circuits, which are used as the peripheral circuits PTR, may be formed on the first substrate 10. Here, the peripheral circuits PTR may include MOS transistors using the first substrate 10 as channel regions thereof.

The lower insulating layer 50 may include one insulating layer or a plurality of vertically-stacked insulating layers covering the peripheral circuits PTR. As an example, the lower insulating layer 50 may include the first lower insulating layer 51, the second lower insulating layer 55, and the etch stop layer 53 between the first lower insulating layer 51 and the second lower insulating layer 55. In an embodiment, the lower insulating layer 50 may include a silicon oxide layer, a silicon nitride layer, a silicon oxynitride layer, and/or a low-k dielectric layer.

The peripheral contact plugs PCP may be formed to penetrate portions of the lower insulating layer 50 and to be connected to the peripheral circuits PTR. The peripheral circuit lines PLP may be formed by performing a process of depositing and patterning a conductive layer.

The first bonding pads BP1 may be formed in the uppermost second lower insulating layer 55 of the lower insulating layer 50. The first bonding pads BP1 may be electrically connected to the peripheral circuits PTR through the peripheral contact plugs PCP and the peripheral circuit lines PLP.

The first bonding pads BP1 may be formed using a damascene process. Top surfaces of the first bonding pads BP1 may be substantially coplanar with a top surface of the second lower insulating layer 55. In the following description, the expression of "two elements are coplanar with each other" may mean that a planarization process may be performed on the elements. The planarization process may be performed using, for example, a chemical mechanical polishing (CMP) process or an etch-back process.

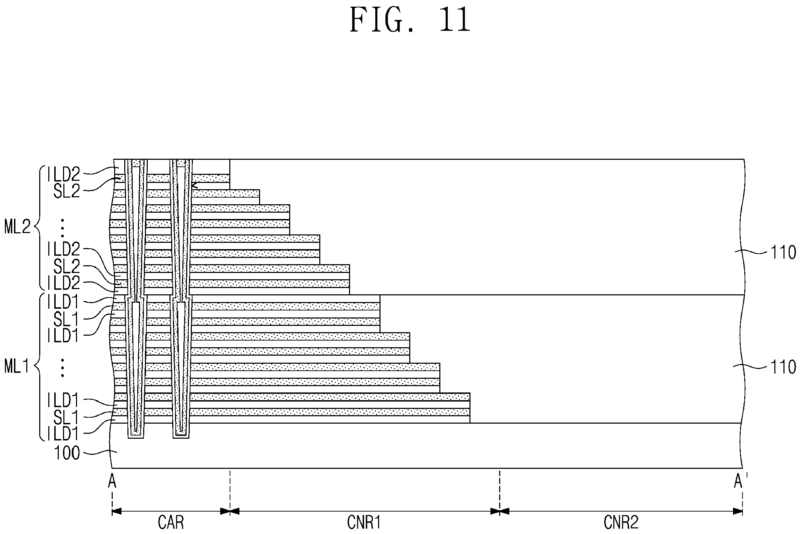

In FIGS. 5 and 11, a first mold structure ML1 may be formed on a second substrate 100. The formation of the first mold structure ML1 may include forming a first layered structure, in which the first interlayer insulating layers ILD1 and first sacrificial layers SL1 are vertically and alternately stacked, and repeatedly performing a patterning process on the first layered structure. Accordingly, the first mold structure ML1 may be formed to have a staircase structure in the first connection region CNR1.

The first interlayer insulating layers ILD1 and the first sacrificial layers SL1 may be deposited by a Thermal Chemical Vapor Deposition (Thermal CVD) process, A Plasma-Enhanced Chemical Vapor Deposition (PE-CVD) process, a physical Chemical Vapor Deposition (physical CVD) process, or an Atomic Layer Deposition (ALD) process.

The first sacrificial layers SL1 of the first mold structure ML1 may be formed of a material which can be etched with a high etch selectivity with respect to the first interlayer insulating layers ILD1. In an embodiment, the first sacrificial layers SL1 may be formed of or include an insulating material different from the first interlayer insulating layers ILD1. For example, the first sacrificial layers SL1 may be formed of or include silicon nitride, and the first interlayer insulating layers ILD1 may be formed of or include silicon oxide.

After the formation of the first mold structure MI,1, the planarization insulating layer 110 may be formed to cover the staircase structure of the first mold structure ML1.

Next, a second mold structure ML2 may be formed on the first mold structure MI,1. In an embodiment, vertical sacrificial patterns may be formed to penetrate the first mold structure ML1, before the formation of the second mold structure ML2.

The formation of the second mold structure ML2 may be substantially the same as the formation of the first mold structure ML1 described above. For example, the formation of the second mold structure ML2 may include forming a second layered structure, in which second interlayer insulating layers ILD2 and second sacrificial layers SL2 are vertically and alternately stacked, on the first mold structure ML1, and repeatedly performing a patterning process on the second layered structure. Accordingly, the second mold structure ML2 may be formed to have a staircase structure in the first connection region CNR1.

The second sacrificial layers SL2 may be formed of or include the same material as the first sacrificial layers SL1 and may have substantially the same thickness as the first sacrificial layers SL1. The second sacrificial layers SL2 may be formed of or include an insulating material that is different from the second interlayer insulating layers ILD2. The second sacrificial layers SL2 may be formed of or include the same material as the first sacrificial layers SL1. For example, the second sacrificial layers SL2 may be formed of or include silicon nitride, and the second interlayer insulating layers ILD2 may be formed of or include silicon oxide. After the formation of the second mold structure ML2, the planarization insulating layer 110 may be formed to cover the staircase structure of the second mold structure ML2.

Next, vertical channel holes may be formed to penetrate the first and second mold structures ML1 and ML2 and to expose the second substrate 100. In the case where the vertical sacrificial patterns are formed in the first mold structure ML1, the formation of the vertical channel holes may include removing the vertical sacrificial patterns to expose the second substrate 100. When the vertical channel holes are formed, dummy channel holes may be formed in the first connection region CNR1 to penetrate the planarization insulating layer 110 and at least a portion of the first and second mold structures ML1 and ML2.

The formation of the vertical channel holes may include forming a hard mask pattern on the second mold structure MI,2 and anisotropically etching the first and second mold structures ML1 and ML2 using the hard mask pattern as an etch mask. The anisotropic etching process of forming the vertical channel holes may be performed in an over-etching manner, and in this case, a top surface of the second substrate 100 exposed by the vertical channel holes may be recessed to specific depths. Furthermore, the recess depths of the second substrate 100 may vary depending on positions of the vertical channel holes in the anisotropic etching process of forming the vertical channel holes.

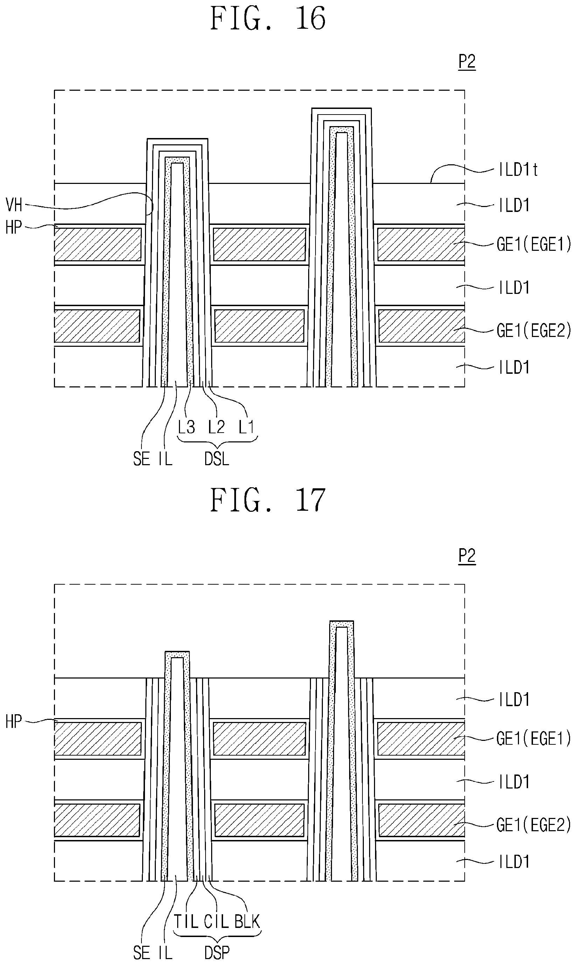

Next, the first vertical structures VS1 may be formed in the vertical channel holes of the cell array region CAR, and the second vertical structures VS2 may be formed in the dummy channel holes of the first connection region CNR1. The formation of the first and second vertical structures VS1 and VS2 may include sequentially depositing the data storing layer DSL (e.g., DSL of FIG. 16) and the vertical channel layer SE (e.g., of FIG. 16) in the vertical channel holes and etching and planarizing the data storing layer and the vertical channel layer.

The data storing layer may be conformally deposited on bottom and side surfaces of the vertical channel holes by a Chemical Vapor Deposition (CVD) method or an Atomic Layer Deposition (ALD) method. The data storing layer may include a blocking insulating layer, a charge storing layer, and a tunneling insulating layer, which are sequentially stacked in the vertical channel holes. The vertical channel layer may be conformally deposited on the data storing layer by a Chemical Vapor Deposition (CVD) method or an Atomic Layer Deposition (ALD) method. After the formation of the data storing layer and the vertical channel layer, the vertical channel holes may be filled with a gapfill insulating layer. Accordingly, the data storage pattern DSP, the vertical channel pattern VC, and the vertical insulating pillar VI may be formed in each vertical channel hole, as described above.

Next, the bit line conductive pads may be formed in top portions of the vertical channel patterns VC. The bit line conductive pads may be an impurity-doped region or may be formed of or include at least one of conductive materials. Top surfaces of the bit line conductive pads may be coplanar with a top surface of the uppermost second upper insulating layer ILD2.

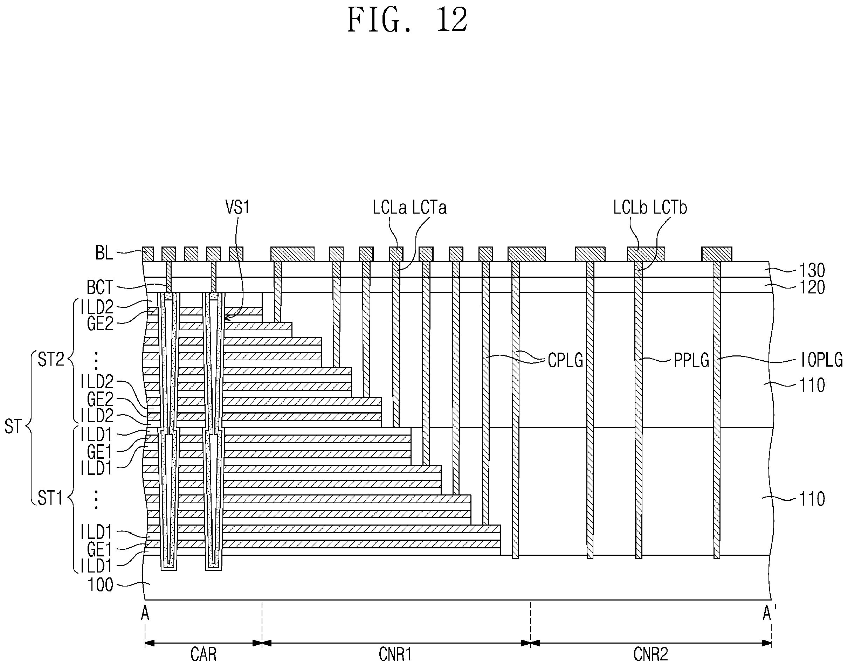

In FIGS. 5 and 12, the first interlayer insulating layer 120 may be formed on the planarization insulating layer 110 to cover top surfaces of the first and second vertical structures VS1 and VS2.

Next, a process may be performed to replace the first and second sacrificial layers SL1 and SL2 of the first and second mold structures ML1 and ML2 with the first and second conductive patterns GE1 and GE2. Accordingly, the stack ST may be formed on the second substrate 100.

The process of replacing the first and second sacrificial layers SL1 and SL2 with the first and second conductive patterns GE1 and GE2 may include isotropically etching the first and second sacrificial layers SL1 and SL2 using an etch recipe having an etch selectivity with respect to the first and second interlayer insulating layers ILD1 and ILD2, the first and second vertical structures VS1 and VS2, and the second substrate 100.

After the formation of the stack ST, the second interlayer insulating layer 130 may be formed on the first interlayer insulating layer 120, and then, the cell contact plugs CPLG, which are connected to the stack ST, the peripheral contact plugs PPLG, and the input/output contact plug IOPLG may be formed.

The formation of the peripheral contact plugs PPLG and the input/output contact plug IOPLG may include forming contact holes to penetrate the first interlayer insulating layers 120 and the planarization insulating layer 110 in the second connection region CNR2 and to expose the second substrate 100 and filling the contact holes with a conductive material.

The second interlayer insulating layer 130 may be formed on the first interlayer insulating layer 120, and then, the bit line contact plugs BCT and connection contact plugs may be respectively formed in the cell array region CAR and the first and second connection regions CNR1 and CNR2.

The bit line contact plugs BCT may be provided to penetrate the first interlayer insulating layer 120 and the second interlayer insulating layer 130 and may be connected to the first vertical structures VS1. The bit line contact plugs BCT may be in contact with the bit line conductive pad. The bit line conductive pad may be formed of or include at least one of undoped semiconductor materials, doped semiconductor materials, or conductive materials.

First connection contact plugs may be provided to penetrate the second interlayer insulating layer 130 and may be connected to the cell contact plugs CPLG. Second connection contact plugs may be provided to penetrate the second interlayer insulating layer 130 and may be connected to the peripheral contact plugs PPLG and the input/output contact plug IOPLG.

The bit lines BL and the lower interconnection lines LCLa and LCLb may be formed on the second interlayer insulating layer 130. The bit lines BL may be connected to the bit line contact plugs BCT, and the lower interconnection lines LCLa and LCLb may be connected to the connection contact plugs.

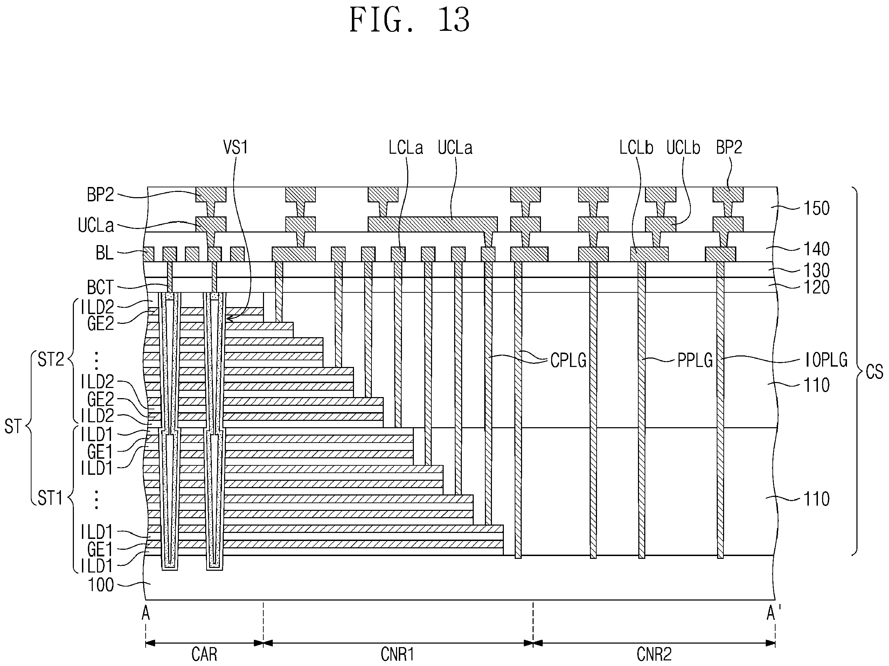

In FIGS. 5 and 13, the third interlayer insulating layer 140 and the fourth interlayer insulating layer 150 may be stacked on the second interlayer insulating layer 130, and the first and second upper conductive lines UCLa and UCLb may be formed on the third interlayer insulating layer 140. The first and second upper conductive lines UCLa and UCLb may be connected to the first and second lower conductive lines LCLa and LCLb.

The first bonding pads BP1 may be formed in the fourth interlayer insulating layer 150 and may be connected to the first and second upper conductive lines UCLa and UCLb.

The first and second upper conductive lines UCLa and UCLb and the first bonding pads BP1 may be formed using a damascene process. Top surfaces of the first bonding pads BP1 may be substantially coplanar with a top surface of the fourth interlayer insulating layer 150.

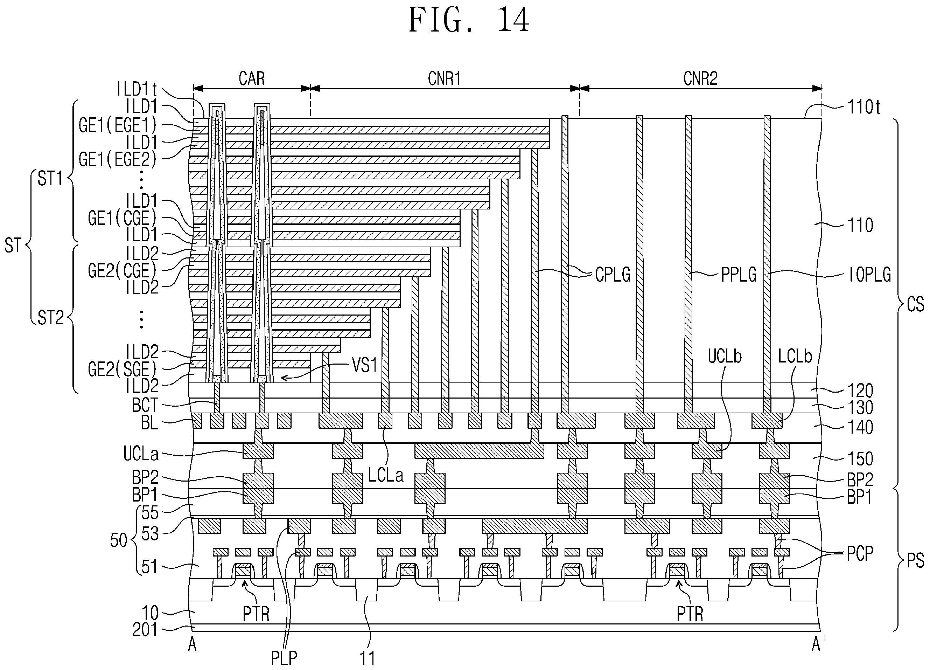

In FIGS. 5 and 14, the cell array structure CS formed on the second substrate 100 may be bonded to the peripheral circuit structure PS, which is formed on the first substrate 10 by the method described with reference to FIG. 10. In more detail, the first bonding pads BP1 of the peripheral circuit structure PS may be bonded to the second bonding pads BP2 of the cell array structure CS.

In an embodiment, the first and second bonding pads BP1 and BP2 may be bonded to each other, and the uppermost one of the interlayer insulating layers on the first substrate 10 may be bonded to the uppermost lower insulating layer 50 on the second substrate 100.

Since the first bonding pads BP1 are bonded to the second bonding pads BP2, the cell array structure CS may have a vertically inverted structure. For example, the second substrate 100 may be placed at the uppermost level of the cell array structure CS, and the staircase structure of the stack ST may be disposed in an inverted shape.

After the bonding of the first and second bonding pads BP1 and BP2, the second substrate 100 may be removed. The removal of the second substrate 100 may be performed by using at least one of a grinding process, a planarization process, a dry etching process, and a wet etching process. As a result of the removal of the second substrate 100, a top surface 110t of the lowermost one of the interlayer insulating layers ILD1 of the stack ST and the top surface 110t of the planarization insulating layer 110 may be exposed to the outside. In addition, since the second substrate 100 is removed, the data storing layer of the first vertical channel structures VS1 may be protruded from the lowermost one off the interlayer insulating layers ILD1, and the peripheral contact plugs PPLG and the input/output contact plug IOPLG may be exposed to the outside of the planarization insulating layer 110.

Next, the upper portion of the data storing layer protruding above the lowermost one of the interlayer insulating layers ILD1 may be removed to expose the top surface of the vertical channel layer.

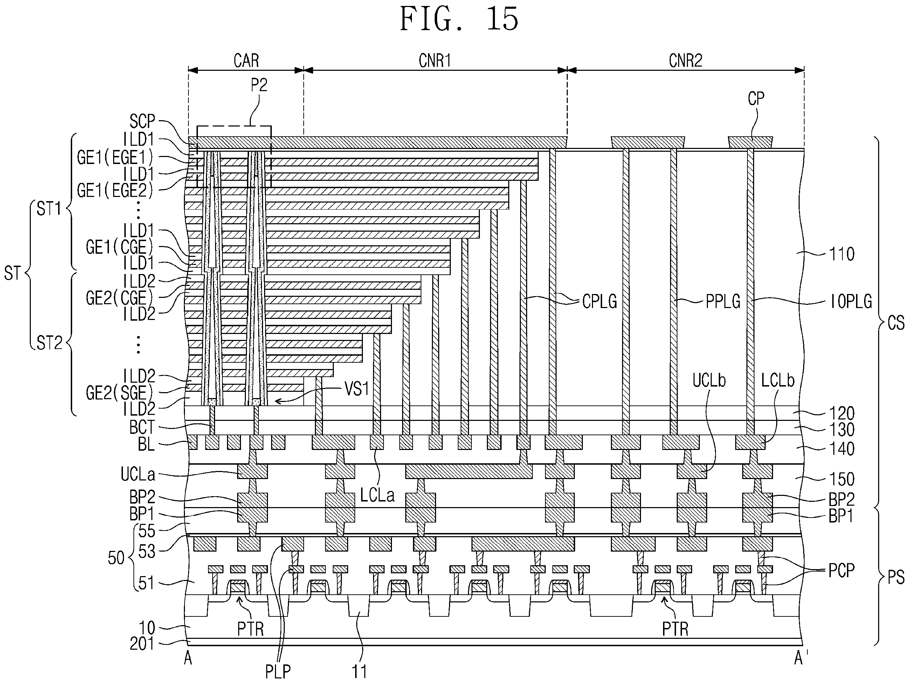

In FIG. 15, the protruding upper portions of the data storing layer and the upper portion of the vertical channel pattern VC may be removed, a vertical conductive pillar may be formed in the vertical channel pattern VC, and the source conductive pattern SCP may be formed on the uppermost one of the interlayer insulating layers ILD1. As an example, the source conductive pattern SCP may include a poly silicon layer that is doped with n-type dopants. The source conductive pattern SCP may be in contact with the vertical channel pattern and the vertical conductive pillar. When the source conductive pattern SCP are formed, the upper conductive patterns CP may be formed on the planarization insulating layer 110 in the first and second connection regions CNR1 and CNR2.

A method of forming the source conductive pattern SCP and the vertical conductive pillar will be described in more detail with reference to FIGS. 16 to 22. Referring back to FIGS. 5, 6A, and 6B, after the formation of the source conductive pattern SCP and the upper conductive pattern CP, the upper insulating layer 310 may be formed on the source conductive pattern SCP and the upper conductive pattern CP, and then input/output pads PAD may be formed on the upper insulating layer 310. The input/output pad may be connected to the input/output contact plug IOPLG through a contact plug penetrating the upper insulating layer 310.

After the formation of the input/output pads PAD, the capping insulating layer 320, a protection layer 330, and the passivation layer 340 may be sequentially formed. The capping insulating layer 320 may include, for example, a silicon oxide layer, a silicon nitride layer, or a silicon oxynitride layer. The protection layer 330 may be, for example, a silicon nitride layer or a silicon oxynitride layer. The passivation layer 340 may be formed of or include polyimide-based materials (e.g., Photo Sensitive Polyimide (PSPI)). The passivation layer 340 may be formed on the protection layer 330 by a spin coating process.

Next, an opening OP exposing a portion of the input/output pad may be formed by partially patterning the capping insulating layer 320, the protection layer 330, and the passivation layer 340.

FIGS. 16 to 22 are enlarged sectional views of a portion `P2' of FIG. 15, which are presented to illustrate a method of forming a source structure of a semiconductor memory device according to an embodiment of the present disclosure.

In FIG. 16, as described with reference to FIG. 14, the peripheral circuit structure PS formed on the first substrate 10 may be bonded to the cell array structure CS, and then, the second substrate 100 of FIG. 13 may be removed. Accordingly, the top surface ILD1t of the uppermost one of the interlayer insulating layers ILD1 of the stack ST may be exposed to the outside. In addition, as a result of the removal of the second substrate 100, a data storing layer DSL, upper portion of a vertical channel layer SE, and a vertical insulating layer IL, which are sequentially formed in each of vertical channel holes CH, may have upper portions that protrude above the top surface ILD1t of the uppermost one of the interlayer insulating layers ILD1. The data storing layer DSL may include a blocking insulating layer L1, a charge storing layer L2, and a tunneling insulating layer L3, which are sequentially stacked in each vertical channel hole CH, and the blocking insulating layer L1 of the data storing layer DSL and the uppermost one of the interlayer insulating layers ILD1 may be used as an etch stop layer in the process of removing the second substrate 100.

In the process of forming the first vertical structures VS1 described with reference to FIG. 11, the vertical channel holes CH may be formed to have at least two different depths in the second substrate 100. Accordingly, after the removal of the second substrate 100, protrusion lengths of the first vertical structures VS1 from the top surface of the uppermost one of the interlayer insulating layers ILD1 may have different values, depending on positions of the vertical channel holes.

In FIG. 17, an isotropic etching process may be performed on the upper portion of the data storage layer DSL protruding above the top surface ILD1t of the uppermost one of the interlayer insulating layers ILD1. Accordingly, the upper portion of the vertical channel layer SE may be exposed, and the data storage pattern DSP may be formed to have a pipe shape with opened top and bottom.

An etch recipe, which is chosen to have an etch selectivity with respect to the vertical channel layer SE, may be used in the isotropic etching process on the data storage layer DSL. The etching process on the data storage layer DSL may include sequentially and isotropically etching the blocking insulating layer BLK, the charge storing layer CIL, and the tunnel insulating layer TIL.

The isotropic etching process may include performing a first etching process of etching a portion of the blocking insulating layer BLK, a second etching process of etching a portion of the charge storing layer CIL, and a third etching process of etching a portion of the tunnel insulating layer TIL. Here, an etching solution containing hydrofluoric acid or sulfuric acid may be used in the first and third etching processes, and an etching solution containing phosphoric acid may be used in the second etching process. A profile of the top surface of the data storage pattern DSP may vary, depending on the etch recipes used in the first, second, and third etching processes.

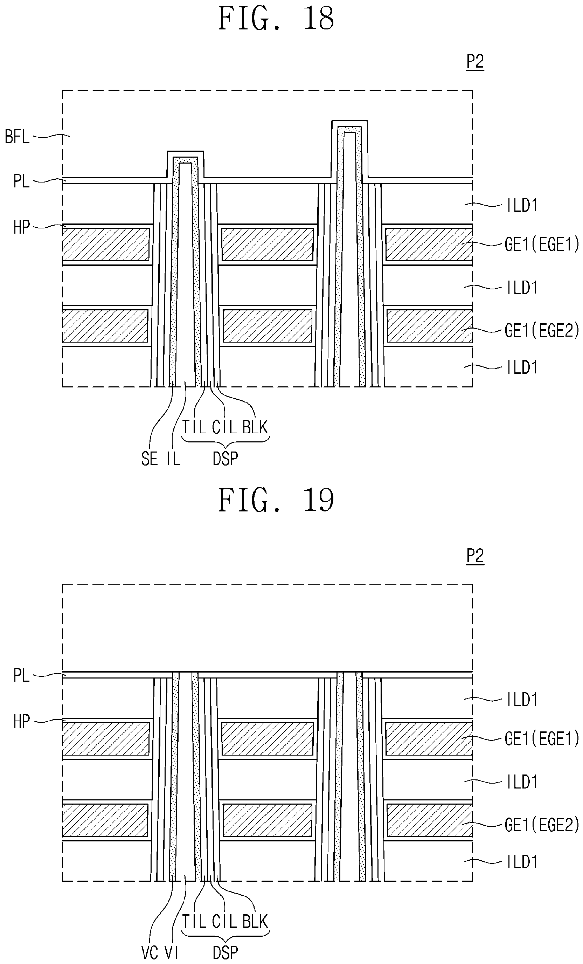

In FIG. 18, the insulating reflection layer PL may be formed to cover the top surface ILD1t of the uppermost one of the interlayer insulating layers ILD1 and the protruding upper portion of the vertical channel layer SE with a uniform thickness.

The insulating reflection layer PL may be formed of or include an insulating material having an etch selectivity with respect to the uppermost one of the interlayer insulating layers ILD1 and the vertical channel layer SE. In an embodiment, the insulating reflection layer PL may include a silicon nitride layer or a silicon oxynitride layer. The insulating reflection layer PL may be deposited using, for example, a Chemical Vapor Deposition (CVD) process or an Atomic Layer Deposition (ALD) process. In an embodiment, the formation of the insulating reflection layer PL may be omitted.

Next, a buffer insulating layer BFL may be formed on the insulating reflection layer PL to cover the protruding upper portions of the vertical channel patterns VC. The buffer insulating layer BFL may be formed of or include at least one of, for example, silicon oxide, silicon nitride, silicon oxynitride, and/or low-k dielectric materials.

In FIG. 19, a planarization process may be performed to remove the protruding upper portion of the vertical channel layer SE. The planarization process may be performed using, for example, a Chemical Mechanical Polishing (CMP) process or an etch-back process. In the planarization process, the insulating reflection layer PL may be used as a planarization stop layer or an etch stop layer.

As a result of planarization process, the upper portion of the vertical channel layer VE and the upper portion of the vertical insulating pillar VI may be removed, and thus, the vertical channel pattern VC may be formed to have a pipe shape with opened top and bottom. The top surface of the vertical channel pattern VC may be substantially coplanar with the top surface of the insulating reflection layer PL or the top surface of the uppermost one of the interlayer insulating layers ILD1.

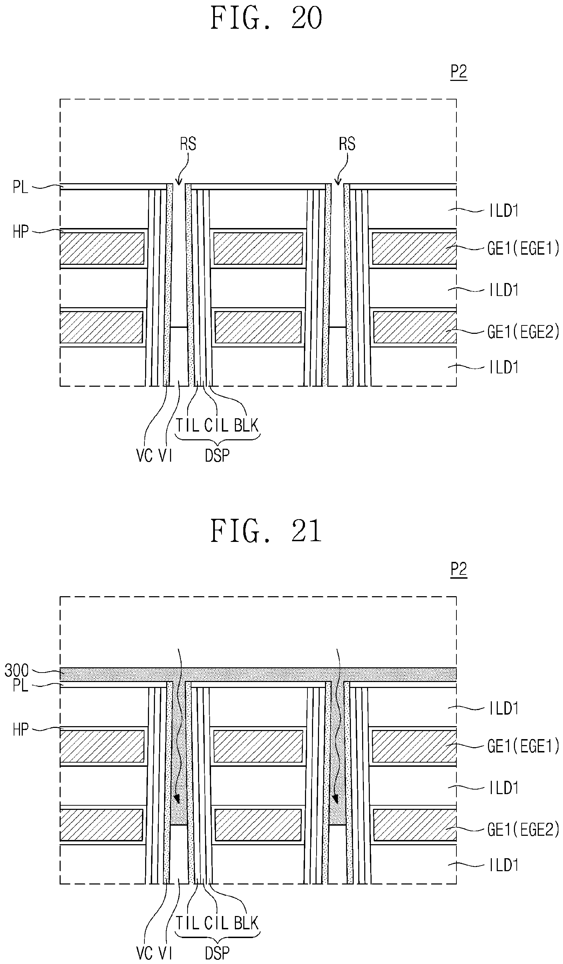

Next, In FIG. 20, a wet or dry etching process or an etch-back process may be performed on the vertical insulating pillar VI to form recess regions RS partially exposing inner side surfaces of the vertical channel patterns VC. An etch recipe, which is chosen to have an etch selectivity with respect to the vertical channel pattern VC, may be used in the etching process on the vertical insulating pillar VI.

As a result of the formation of the recess region RS, the top surface of the vertical insulating pillar VI may be located at a level that is lower than a bottom surface of the uppermost electrode GE1 (i.e., the first erase gate pattern EGE1) and is higher than the bottom surface of the second erase gate pattern EGE2.

In FIG. 21, a (doped) semiconductor layer 300 may be deposited to fill the recess regions RS. The semiconductor layer 300 may be doped with impurities of a first conductivity type (e.g., n-type), during a process of depositing the semiconductor layer 300. In an embodiment, the semiconductor layer 300 may be formed by depositing an amorphous or poly silicon layer and performing a thermal treatment process (e.g., a laser annealing process) on the silicon layer.

When the semiconductor layer 300 is deposited, a void or air gap may be formed in the recess region RS. In an embodiment, a laser annealing process may be performed on the semiconductor layer 300 to melt a polysilicon layer, and in this case, the recess region RS may be fully filled with the (doped) semiconductor layer 300. Furthermore, by performing the laser annealing process, it may be possible to reduce a grain boundary of the semiconductor layer 300. In addition, the insulating reflection layer PL may reflect a laser beam, which is used in the laser annealing process, and this may make it possible to prevent the laser beam from being incident into the uppermost conductive pattern GE1.

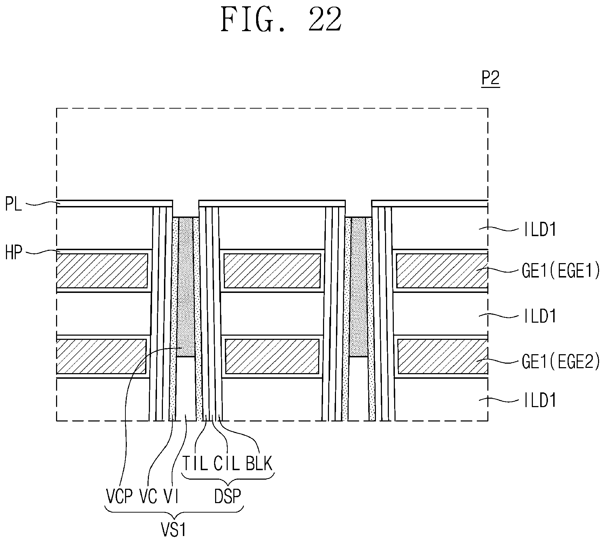

In FIG. 22, an etch-back process may be performed on the semiconductor layer 300 to locally form the vertical conductive pillar VCP in each recess region RS. The etch-back process may be performed such that the top surface of the vertical conductive pillar VCP and the top surface of the vertical channel pattern VC are located at a level lower than the top surface of the data storage pattern DSP.

According to an embodiment of the present disclosure, a vertical structure penetrating a stack may include a vertical conductive pillar connecting a vertical channel pattern to a source conductive pattern. Here, the vertical conductive pillar may be overlapped with the uppermost conductive pattern (e.g., first erase gate pattern). In this case, it may be possible to induce a GIDL phenomenon more easily in an erase operation. This may make it possible to improve electrical characteristics of a semiconductor memory device.

Arrangements are further defined by the clauses E1 to E14 below:
E1. A semiconductor memory device comprising:
   a stack comprising interlayer insulating layers and conductive patterns, which are alternately stacked;
   a source conductive pattern on the stack; and
   vertical structures provided to penetrate the stack, the vertical structures being connected to the source conductive pattern,
   wherein each of the vertical structures comprises:
      a vertical channel pattern;
      a data storage pattern enclosing an outer side surface of the vertical channel pattern;
      a vertical insulating pillar in the vertical channel pattern; and
      a vertical conductive pillar disposed between the vertical insulating pillar and the source conductive pattern, the vertical conductive pillar being connecting the vertical channel pattern to the source conductive pattern.
E2. The semiconductor memory device of E1, wherein a uppermost conductive pattern of the conductive patterns is provided to enclose the vertical conductive pillar and the uppermost conductive pattern is adjacent to the source conductive pattern.
E3. The semiconductor memory device of E1 or E2, wherein the vertical conductive pillar comprises a doped semiconductor material.
E4. The semiconductor memory device of any of E1 to E3, wherein:
   the source conductive pattern comprises (i) a horizontal portion that is parallel to the stack and (ii) protruding portions that protrude from the horizontal portion, and
   the vertical channel pattern and the vertical conductive pillar are in contact with each of the vertical portions.
E5. The semiconductor memory device of E2 or E4, wherein a portion of the data storage pattern encloses each of the vertical portions.
E6. The semiconductor memory device of any of E1 to E5, wherein the conductive patterns comprise (i) a first erase gate pattern that is most adjacent to the source conductive pattern and (ii) a second erase gate pattern that is provided on the first erase gate pattern, and
   an interface between the vertical conductive pillar and the vertical insulating pillar is located at a level between top and bottom surfaces of the second erase gate pattern.
E7. The semiconductor memory device of any of E1 to E6, wherein the source conductive pattern comprises a metallic material.
E8. The semiconductor memory device of any of E1 to E7, further comprising an insulating reflection layer between the source conductive pattern and a uppermost interlayer insulating layer of the interlayer insulating layers.
E9. The semiconductor memory device of E8, wherein the insulating reflection layer is formed of an insulating material different from the interlayer insulating layers.
E10. The semiconductor memory device of E8 or E9, wherein a portion of the insulating reflection layer is disposed between a top surface of the data storage pattern and the source conductive pattern.
E11. The semiconductor memory device any of E1 to E10, wherein the source conductive pattern is in contact with a top surface of the uppermost interlayer insulating layer of the interlayer insulating layers of the stack and a top surface of the data storage pattern.
E12. The semiconductor memory device of any of E1 to E11, further comprising:
   a substrate;
   a peripheral circuit structure comprising (i) peripheral circuits that are integrated on the substrate and (ii) first bonding pads that are connected to the peripheral circuits; and
   second bonding pads that are bonded to the first bonding pads
E13. The semiconductor memory device of E12, further comprising bit lines (i) that are extended in a specific direction to cross the stack and (ii) that are connected to the vertical channel patterns of the vertical structures,
   wherein the bit lines are adjacent to the peripheral circuit structure.
E14. The semiconductor memory device of E12 or E13, further comprising:
   a lower insulating layer covering the source conductive pattern;
   an input/output plug laterally spaced apart from the stack and the source conductive pattern and coupled to one of the second bonding pads; and
   an input/output pad disposed on the lower insulating layer and connected to the input/output plug.

While example embodiments of the present disclosure have been particularly shown and described, it will be understood by one of ordinary skill in the art that variations in form and detail may be made therein without departing from the scope of the attached claims.

## Claims

1. A semiconductor memory device comprising:
a stack comprising interlayer insulating layers and conductive patterns, which are alternately stacked;
a source conductive pattern on the stack; and
structures provided to penetrate the stack, the structures being connected to the source conductive pattern,
wherein each of the structures comprises:
a channel pattern;
a data storage pattern enclosing an outer side surface of the channel pattern;
a insulating pillar in the channel pattern; and
a conductive pillar disposed between the insulating pillar and the source conductive pattern, the conductive pillar connecting the channel pattern to the source conductive pattern.

2. The semiconductor memory device of claim 1, wherein a conductive pattern of the conductive patterns is provided to enclose the conductive pillar and the conductive pattern is adjacent to the source conductive pattern.

3. The semiconductor memory device of claim 1 or 2, wherein the conductive pillar comprises a doped semiconductor material.

4. The semiconductor memory device of any preceding claim, wherein:
the source conductive pattern comprises (i) a portion that is parallel to the stack and (ii) protruding portions that protrude from the parallelportion, and
the channel pattern and the conductive pillar are in contact with each of the protruding portions.

5. The semiconductor memory device of claim 4, wherein a portion of the data storage pattern encloses each of the protruding portions.

6. The semiconductor memory device of any preceding claim, wherein the conductive patterns comprise (i) a first erase gate pattern that is most adjacent to the source conductive pattern and (ii) a second erase gate pattern that is provided on the first erase gate pattern, and
an interface between the conductive pillar and the insulating pillar is located at a level between top and bottom surfaces of the second erase gate pattern.

7. The semiconductor memory device of any preceding claim, wherein the source conductive pattern comprises a metallic material.

8. The semiconductor memory device of any preceding claim, further comprising an insulating reflection layer between the source conductive pattern and an interlayer insulating layer that is the closest of the interlayer insulating layers to the source conductive pattern.

9. The semiconductor memory device of claim 8, wherein the insulating reflection layer is formed of an insulating material different from material of the interlayer insulating layers.

10. The semiconductor memory device of claim 8 or 9, wherein a portion of the insulating reflection layer is disposed between a top surface of the data storage pattern and the source conductive pattern.

11. The semiconductor memory device of any preceding claim, wherein the source conductive pattern is in contact with a surface of an interlayer insulating layer of the interlayer insulating layers of the stack and a surface of the data storage pattern.

12. The semiconductor memory device of any preceding claim, further comprising:
a substrate;
a peripheral circuit structure comprising (i) peripheral circuits that are integrated on the substrate and (ii) first bonding pads that are connected to the peripheral circuits; and
second bonding pads that are bonded to the first bonding pads.

13. The semiconductor memory device of claim 12, further comprising bit lines that are (i) extended in a specific direction to cross the stack and (ii) connected to the channel patterns of the structures,
wherein the bit lines are adjacent to the peripheral circuit structure.

14. The semiconductor memory device of claim 12 or 13, further comprising:
a lower insulating layer covering the source conductive pattern;
an input/output plug laterally spaced apart from the stack and the source conductive pattern and coupled to one of the second bonding pads; and
an input/output pad disposed on the lower insulating layer and connected to the input/output plug.

15. The semiconductor memory device of any preceding claim, wherein the structures, channel pattern, insulating pillar and conductive pillar extend in a same direction and/or are vertical.
